# EUROPEAN PATENT APPLICATION

(11) **EP 1 998 599 A1**
(43) Date of publication of application: **03.12.2008**
(21) Application number: 07714898.9
(22) Date of filing: 26.02.2007
(51) Int. Cl.: H05B 33/12, H01L 51/50

(54) **LIGHT EMITTING DEVICE**

(30) Priority: 23.03.2006 JP 2006080861; 31.03.2006 JP 2006099039
(71) Applicant: Idemitsu Kosan Co., Ltd., Chiyoda-ku Tokyo 100-8321 (JP)
(72) Inventor: EIDA, Mitsuru, Sodegaura-shi, Chiba 299-0293 (JP); KUMA, Hitoshi, Sodegaura-shi, Chiba 299-0293 (JP); HOSOKAWA, Chishio, Sodegaura-shi, Chiba 299-0293 (JP); FUKUDA, Masahiko, Sodegaura-shi, Chiba 299-0293 (JP)
(74) Representative: Gille Hrabal Struck Neidlein Prop Roos
(86) International application number: PCT/JP2007/053466
(87) International publication number: WO 2007/122857

(57) **Abstract**

A light emitting apparatus (1) including: a supporting substrate (10), a fluorescence medium (20) and an emitting device (30) for covering the fluorescence device (20); the emitting device (30) having two or more emitting surfaces which are not parallel to each other; wherein the light emitting apparatus (1) emits light obtained by mixing light emitted by the emitting device (30) and light emitted by the fluorescence medium (20).

## Description

### TECHNICAL FIELD

The invention relates to a light emitting apparatus used in a common illuminator, a backlight for a liquid crystal display, or the like. In particular, the invention relates to a white light emitting apparatus having a relatively large area, which includes a fluorescence medium. In addition, the invention relates to a light emitting apparatus, especially, an organic electroluminescence (EL) apparatus utilized in the field of illumination such as a common illuminator and a backlight for a liquid crystal display.

### BACKGROUND

A light emitting apparatus used in a common illuminator or a backlight (for a liquid crystal display) is required to be thin, simple in configuration, capable of being large in size, capable of performing uniform plane emission, and have high efficiency as well as high durability.
An organic electroluminescence (EL) device can provide a light emitting apparatus which is thin and capable of performing uniform plane emission. It is known from Patent Document 1 or other documents that white emission is obtained easily by mixing light emitted from a blue emitting device and fluorescence from a fluorescence layer.

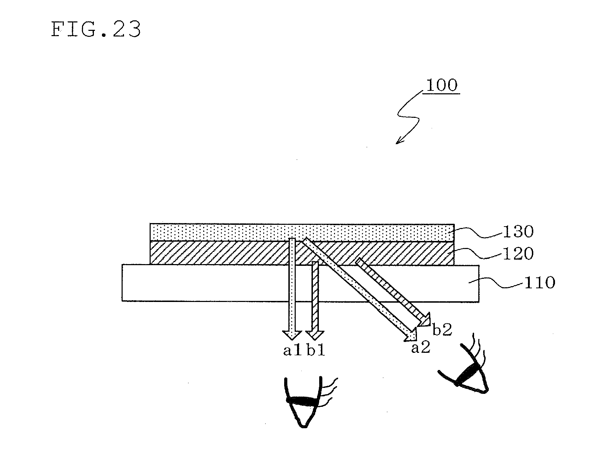

Patent Document 2 discloses a light emitting apparatus 100 comprising a blue-emitting device (thin film EL device) 130 and a fluorescent medium (color conversion layer) 120 as shown in FIG.23. This light emitting apparatus 100 comprises a supporting substrate 110, and a fluorescence medium (color conversion layer) 120 and an emitting device 130 thereon in this order, in which the fluorescence medium 120 and the emitting device 130 are in parallel to the supporting substrate 110. The color conversion layer 120 is a single layer in which a blue/green conversion material which converts part of the photoenergy of blue light to the photoenergy of green light and a green/red conversion material which converts part of the photoenergy of blue and green light to the photoenergy of red light are mixed and dispersed.

In the light emitting apparatus shown in FIG. 23, light rays emitted by the emitting device 130 (a1 + b1, a2 + b2) have different emission spectra depending on the viewing angle due to light interference within the emitting device.
In addition, there is a difference in the distance for which a light ray transmits the color conversion layer 120 between the light ray which transmits the layer 120 from the front (a1) and the light ray which transmits the layer 120 obliquely (a2), which results in difference in the amount of light absorbed by the color conversion layer 120. Therefore, the intensity of light which is emitted by the emitting device 130 and transmits the color conversion layer 120 varies depending on the viewing angle.

As mentioned above, even though fluorescence (b1, b2) emitted by the color conversion layer 120 is an isotropic emission of which the fluorescent spectrum and strength do not change depending on the viewing angle, the emission spectrum and emission intensity of light emitted by the emitting device 130 (transmission light) (a1, a2) vary depending on the viewing angle. As a result, the hue of white light obtained by mixing light emitted by the emitting device and light generated from the color conversion layer (a1 + b1, a2 + b2) has view angle dependency. For this reason, uniform plane emission cannot always be obtained by the light emitting apparatus shown in FIG. 23.

Patent Document 3 discloses an organic EL color display comprising a blue-green-light-emitting organic EL device, a blue-light-transmitting layer, a green-light-transmitting layer, a fluorescence conversion layer which absorbs blue-green light and emits light containing red light, and a red-light-transmitting layer. In the Patent Document 3, the EL device is formed in such a way that it covers at least the fluorescence conversion layer.
Since the apparatus disclosed in this document is a color display, out coupling of light obtained by mixing light emitted by the emitting device and light emitted by the fluorescence conversion layer (white light, for example) is not intended. Therefore, the light emitted by the emitting device is fully absorbed by the fluorescence conversion layer or a red-transmitting layer is arranged so that the light leaked from the emitting device is blocked by the red-transmitting layer. Furthermore, the anode (electrode) of the emitting device is not covered in the entire emission region. Specifically, to enable selective emission of each color, the anode (transparent electrode) of the emitting device is patterned according to each transmitting layer or fluoresce conversion layer. Therefore, this conventional technology cannot provide a light emitting apparatus which emits a mixture of light transmitting the fluorescence conversion layer and fluorescence converted by the fluorescence conversion layer (white-light-emitting apparatus, for example). Furthermore, the technology does not encounter with the problems associated with the view angle dependency.

Patent Documents 4 and 5 each disclose a white-light-emitting apparatus in which a fluorescence medium (light conversion part) is providedH adjacent to the emitting part of an organic emitting device (in the lateral direction). In each of the light emitting apparatuses disclosed in these documents, the electrode of the emitting device does not cover the fluorescence medium, and degasification of moisture generated from the color conversion part occurs. As a result, the apparatuses of these documents suffer from the problems that the organic EL device deteriorates or white emission varies depending on the viewing angle.

An organic EL device is a self-emitting, perfectly solid device which has benefits that it can be light in weight, can be formed into a thin film, and can be driven at a low direct voltage or the like. Therefore, an organic EL device has been briskly developed not only as a next-generation display but also as a large-area illuminator. Depending on the light outcoupling method, an organic EL device is divided into a bottom-emission type and a top-emission type. The former organic EL device has a configuration in which a transparent electrode is formed on a light-transmitting supporting substrate, and an organic emitting layer and a counter electrode are stacked thereon. In this organic EL device, light generated in an organic emitting layer is outcoupled from the transparent supporting substrate. The latter organic EL device has a configuration in which a reflective electrode is formed on a supporting substrate, and an organic emitting layer and a transparent counter electrode are stacked thereon. In this organic EL device, light generated in an organic emitting layer is outcoupled from the transparent counter electrode.

In developing an illuminator, technologies of obtaining white emission are required. As one of these technologies, a technology is known in which a plurality of emitting layers differing in color are stacked to enable white light to emit. Patent Document 6 discloses a white-light-emitting device obtained by stacking three emitting layers, i.e. a red emitting layer, a green emitting layer and a blue emitting layer. Patent Document 7 discloses a white-light-emitting device in which emitting layers of two complementary colors are stacked. A technique is known in which white emission is obtained by mixing emission from an organic emitting device and emission obtained by subjecting part of this emission to color conversion. Patent Document 2 discloses a technology in which a color conversion layer is provided outside a blue-emitting device, and the color conversion layer is a single layer in which a blue/green conversion material converting blue to green and a blue/red conversion material converting blue to red are mixed and dispersed. Patent Document 8 discloses a light source comprising an organic emitting device which emits light having a first spectrum and a fluorescent material layer which absorbs part of the light released by the organic emitting device and emits light having a second spectrum, in which the part of light absorbed by the fluorescent material layer is not all of the light emitted by the organic emitting device.

Generally, outside an organic emitting layer, several thin layers including a transparent electrode, a cap layer and a transparent passivation layer are provided. Therefore, in conventional organic EL apparatuses, light emitted by an organic emitting layer inevitably passes through the above-mentioned plurality of thin layers provided outside the organic emitting layer and then reaches to the observer's eyes. When light passes through the thin films, dispersion (due to the difference in refractive index of each wavelength) or converging (a multi-layer film or a Bragg's reflection film) occurs. As a result, variation in light intensity or color shift tends to occur according to a user's observation angle. This problem imposes restrictions on the use of the conventional organic light emitting apparatuses (view angle dependency).

Patent Document 9 discloses a light emitting apparatus in which an organic EL layer is formed in a convex shape, and the normal line of light generated from the emitting layer is perpendicular to the surface of a spherical projection. Therefore, in this apparatus, since the intensity of light emitted from the surface of the spherical projection in any direction is uniform, no difference in color or intensity of light is observed even when an observer observes this light emitting apparatus from any direction.

In the organic EL device, of the emission from a luminescence medium, the amount of the total reflected components and the components propagated in the plane direction of the upper and lower electrodes is large since the difference in refractive index between a supporting substrate and air is large. Therefore, if a calculation is made with the refractive index of ITO as 2.00, the refractive index of glass as 1.45 and the refractive index of the emitting layer as 1.60, the loss caused by the above-mentioned components is 80%. In order to improve the light outcoupling efficiency, Patent Document 4 discloses a self-emitting apparatus in which a light-conversion part is provided in adjacent to an organic EL part. According to this invention, due to the provision of the light-conversion part, the entire front luminance can be improved by 120 to 140%.

Patent Document 5 discloses a composite light emitting apparatus in which a fluorescence film is provided in a direction different from the direction of outcoupling light emitted from a luminescent medium. This document discloses an embodiment in which a fluorescence film is provided in a direction perpendicular to the light outcoupling direction and an embodiment in which a luminescent medium is surrounded by a fluorescence medium.
Patent Document 1: JP-A-H3-152897
Patent Document 2: JP-A-H9-213478
Patent Document 3: JP-A-H10-177895
Patent Document 4: JP-A-2005-56813
Patent Document 5: JP-A-2005-71920
Patent Document 6: JP-A-2004-6165
Patent Document 7: JP-A-2002-272857
Patent Document 8: JP-A-2001-223078
Patent Document 9: JP-A-2005-174914

An object of the invention is to provide a white-light-emitting apparatus with a small view angle dependency.

Another object of the invention is to provide an organic EL apparatus improved in view angle dependency, luminous efficiency and light outcoupling efficiency.

### Disclosure of the Invention

The invention provides the following light emitting apparatus.
1. A light emitting apparatus comprising:
   a supporting substrate, a fluorescence medium and an emitting device for covering the fluorescence device;
   the emitting device having two or more emitting surfaces which are not parallel to each other;
   wherein the light emitting apparatus emits light obtained by mixing light emitted by the emitting device and light emitted by the fluorescence medium.
2. The light emitting apparatus according to 1, wherein, when light rays are emitted from the emitting surfaces which are not parallel to each other in the normal directions to the emitting surfaces, and transmit the fluorescence medium, transmission distances in the fluorescence medium are substantially equal.
3. The light emitting apparatus according to 1 or 2, wherein the fluorescence medium is in a convex shape.
4. The light emitting apparatus according to any one of 1 to 3, wherein part of the emitting device covers the fluorescence medium and part of the emitting device does not cover the fluorescence medium.
5. The light emitting apparatus according to 4, wherein a convex part or a concave part is provided on the supporting substrate, and the part of the emitting device which does not cover the fluorescence medium is formed on the convex part or the concave part.
6. The light emitting apparatus according to any one of 1 to 5, wherein a convex part is provided on the supporting substrate, and the fluorescence medium is formed on the convex part in a substantially uniform thickness.
7. The light emitting apparatus according to any one of 1 to 6, wherein a transparent barrier layer is further provided between the emitting device and the fluorescence medium.
8. The light emitting apparatus according to any one of 1 to 7, wherein a transparent electrode of the emitting device functions as a transparent barrier layer.
9. The light emitting apparatus according to any one of 1 to 8, wherein a concave part is provided on the supporting substrate, and the emitting device and the fluorescence medium are formed within the concave part.
10. The light emitting apparatus according to any one of 1 to 9, wherein light emitted by the emitting device and light emitted by the fluorescence medium are outcoupled from the supporting substrate.
11. The light emitting apparatus according to any one of 1 to 9, wherein light emitted by the emitting device and light emitted by the fluorescence medium are outcoupled in the direction away from the supporting substrate.
12. The light emitting apparatus according to any one of 1 to 11, wherein the fluorescence medium contains a nanocrystal fluorescent material.
13. The light emitting apparatus according to 12, wherein the nanocrystal fluorescent material is a semiconductor nanocrystal.
14. The light emitting apparatus according to any one of 1 to 13, wherein the emitting device is an organic electroluminescence device.
15. The light emitting apparatus according to any one of 1 to 14, wherein light obtained by mixing the light emitted by the emitting device and the light emitted by the fluorescence medium is white.
16. A light emitting apparatus comprising:
   a supporting substrate, an emitting device having two or more emitting surfaces which are not parallel to each other and a fluorescence medium;
   the fluorescence medium being disposed in a direction different from the direction in which light emitted by the emitting device is outcoupled;
   wherein the light emitting apparatus emits light obtained by mixing light emitted by the emitting device and light emitted by the fluorescence medium.
17. The light emitting apparatus according to 16, wherein the surface of the emitting device is in a convex shape.
18. The light emitting apparatus according to 16 or 17, wherein the surface of the fluorescence medium is in a convex shape.
19. The light emitting apparatus according to 17 or 18, wherein the convex shape is a semi-spherical shape.
20. The light emitting apparatus according to any of 16 to 19, wherein the fluorescence medium is arranged in a direction perpendicular to the direction in which the light emitted by the emitting device is outcoupled.
21. The light emitting apparatus according to any one of 16 to 20, wherein two or more emitting devices are arranged on the supporting substrate, and the fluorescence medium is between the two or more emitting devices.
22. The light emitting apparatus according to any one of 16 to 21, wherein the emitting device is embedded in the fluorescence medium.
23. The light emitting apparatus according to any one of 16 to 22, wherein the two or more emitting devices are stacked.
24. The light emitting apparatus according to any one of 16 to 23, wherein the light emitted by the emitting device and the light emitted by the fluorescence medium are outcoupled from the supporting substrate.
25. The light emitting apparatus according to any one of 16 to 23, wherein the light emitted by the emitting device and the light emitted by the fluorescence medium are outcoupled in the direction away from the supporting substrate.
26. The light emitting apparatus according to any one of 16 to 25, wherein the fluorescent medium contains a nanocrystal fluorescent material.
27. The light emitting apparatus according to 26, wherein the nanocrystal fluorescent material is a semiconductor nanocrystal.
28. The light emitting apparatus according to any one of 16 to 27, wherein light obtained by mixing the light emitted by the emitting device and the light emitted by the fluorescence medium is white.

According to the invention, a light emitting apparatus with a reduced view angle dependency can be provided.
In addition, the light emitting apparatus of the invention can have an improved luminous efficiency per unit area even though the input voltage of the emitting device is restricted.
Furthermore, since the electrodes of the emitting device continuously cover the fluorescence medium, the emitting device is prevented from being adversely affected by moisture or the like generated from the fluorescence medium.

The invention provides an organic light emitting apparatus improved in view angle dependency, luminous efficiency and light outcoupling efficiency.

### BRIEF DESCRIPTION OF THE DRAWINGS

FIG. 1 is a cross sectional view of embodiment 1 of a light emitting apparatus according to the first aspect;
FIG. 2 is a CIE-chromaticity chart;
FIG. 3 is a cross sectional view of another embodiment of a light emitting apparatus according to the first aspect;
FIG. 4 is a cross sectional view of another embodiment of a light emitting apparatus according to the first aspect;
FIG. 5 is a cross sectional view of another embodiment of a light emitting apparatus according to the first aspect;
FIG. 6 is a cross sectional view of another embodiment of a light emitting apparatus according to the first aspect;
FIG. 7 is a cross sectional view of another embodiment of a light emitting apparatus according to the first aspect;
FIG. 8 is a cross sectional view of embodiment 2 of a light emitting apparatus according to the first aspect;
FIG. 9 is a cross sectional view of another embodiment of a light emitting apparatus according to the first aspect;
FIG. 10 is a cross sectional view of another embodiment of a light emitting apparatus according to the first aspect;
FIG. 11 is a cross sectional view of embodiment 3 of a light emitting apparatus according to the first aspect;
FIG. 12 (a) is a cross sectional view of another embodiment, which is of top-emission type, of a light emitting apparatus according to the first aspect;
FIG. 12 (b) is a cross sectional view of another embodiment, which is of bottom-emission type, of a light emitting apparatus according to the first aspect;
FIG. 13(a) is a cross sectional view of a light emitting apparatus obtained by using the light emitting apparatus 1 shown in FIG. 1 as a basic unit and continuously arranging the light emitting apparatuses 1;
FIG. 13 (b) is a cross sectional view of a light emitting apparatus obtained by using the light emitting apparatus 3 shown in FIG. 4 as a basic unit and continuously arranging the light emitting apparatuses 3;
FIG. 13 (c) is a cross sectional view of a light emitting apparatus obtained by using the light emitting apparatus 7 shown in FIG. 8 as a basic unit and continuously arranging the light emitting apparatuses 7;
FIG. 13 (d) is a cross sectional view of a light emitting apparatus obtained by using the light emitting apparatus 8 shown in FIG. 9 as a basic unit and continuously arranging the light emitting apparatuses 8;
FIG. 13 (e) is a cross sectional view of a light emitting apparatus obtained by using the light emitting apparatus 9 shown in FIG. 10 as a basic unit and continuously arranging the light emitting apparatuses 9;
FIG. 14(a) is a cross sectional view of embodiment 1 of a light emitting apparatus according to the second aspect;
FIG. 14 (b) is a cross section view of an emitting surface of the light emitting apparatus according to embodiment 1;
FIG. 15 is a cross sectional view of another embodiment of a light emitting apparatus according to the second aspect;
FIG. 16 is a cross sectional view of another embodiment of the light emitting apparatus according to the second aspect;
FIG. 17 is a cross sectional view of another embodiment of the light emitting apparatus according to the second aspect;
FIG. 18 is a cross sectional view of embodiment 2 of the light emitting apparatus according to the second aspect;
FIG. 19 is a cross sectional view of another embodiment of the light emitting apparatus according to the second aspect;
FIG. 20 (a) is a cross sectional view of a light emitting apparatus obtained by using the light emitting apparatus 1 shown in FIG. 14(a) as a basic unit and continuously arranging the light emitting apparatuses 1;
FIG. 20 (b) is a cross sectional view of a light emitting apparatus obtained by using the light emitting apparatus 2 shown in FIG. 17 as a basic unit and continuously arranging the light emitting apparatuses 2;
FIG. 20 (c) is a cross sectional view of a light emitting apparatus obtained by using the light emitting apparatus 3 shown in FIG. 18 as a basic unit and continuously arranging the light emitting apparatuses 3;
FIG. 20 (d) is a cross sectional view of a light emitting apparatus obtained by using the light emitting apparatus 4 shown in FIG. 19 as a basic unit and continuously arranging the light emitting apparatuses 4;
FIG. 21 is a pattern view showing the convex part and the fluorescence medium prepared in Example 10;
FIG. 22 is a view showing the vertical direction of the light emitting apparatus prepared in Example 15; and
FIG. 23 is a cross sectional view showing a conventional light emitting apparatus.

### BEST MODE FOR CARRYING OUT THE INVENTION

The light emitting apparatus according to the first aspect of the invention will be described in detail with reference to the drawings.

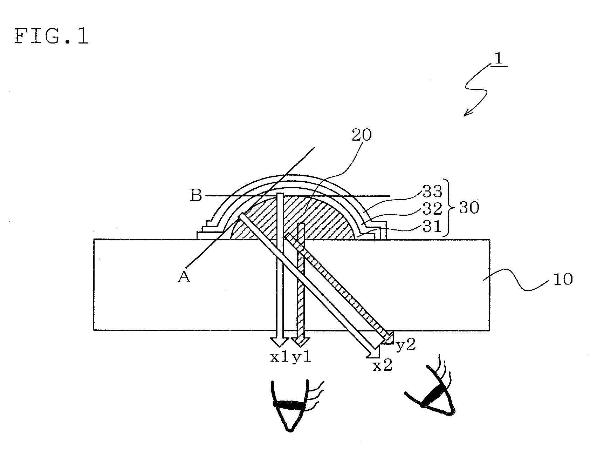

FIG. 1 is a cross sectional view of embodiment 1 of the light emitting apparatus according to the first aspect of the invention.
As shown in FIG. 1, in the light emitting apparatus 1, a fluorescence medium (color conversion layer) 20 in a semi-circular cross sectional shape is arranged on a supporting substrate 10, and the fluorescence medium 10 is covered by an emitting device 30.
The shape of the fluorescence medium is not particularly limited insofar as it has a semi-circular cross section. The fluorescence medium may be in a semi-spherical or semi-cylindrical shape with a slightly flattened top. In the invention, the "covered" is intended to mean that the emitting devices 30 are continuously arranged relative to the upper and side surfaces of the fluorescence medium 20; specifically, the emitting device 30 is in close contact with or around the upper and side surfaces of the fluorescence medium 20.

The emitting device 30 is an organic EL device comprising a first electrode 31, an organic luminescent medium 32 and a second electrode 33. It is preferred that the first electrode 31 be a transparent electrode which prevents a gas, moisture or the like of the fluorescence medium 20 from entering to the emitting device 30. Specifically, since the transparent electrode of the emitting device completely covers the fluorescence medium 20, deteriorating components in the fluorescence medium 20 can be blocked more completely, whereby durability of the emitting device 30 can be improved.
As the transparent electrode, an amorphous film is preferable, since a dense film can be formed and barrier properties can be improved.

In the light emitting apparatus 1, since the emitting device 30 covers the fluorescence medium 20 having a semi-circular cross section, the emitting device 30 has a plurality of emitting surfaces A, B and the like which are not parallel to each other. In the invention, the "emitting surface" means the surface of the emitting device 30 which emits light into the fluorescence medium 20 at a right angle thereto. When the emitting device 30 is in contact with the fluorescence medium 20, the "emitting surface" means the contact surface between the emitting device 30 and the fluorescence medium 20.

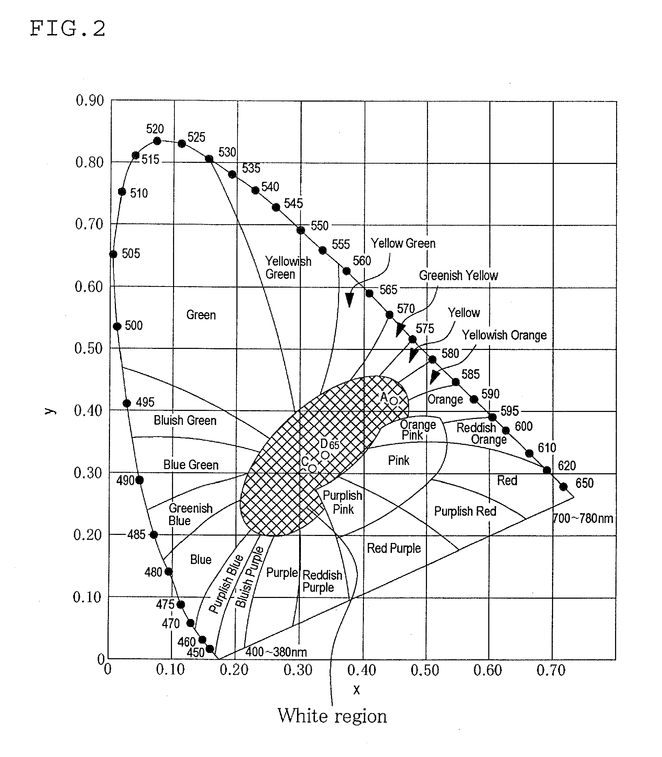

In this light emitting apparatus 1, the original light rays (x1, x2) emitted from the emitting device 30 and the light rays (fluorescence) (y1, y2) emitted from the fluorescence medium 20, which are generated by converting the light emitted from the emitting device 30, are mixed, and the resulting mixed light rays are emitted through the supporting substrate 10 (x1 + y1, x2 + y2). It is preferred that the color of emission obtained by this mixing be white. Since the color of emission is white, it is possible to apply the light emitting apparatus to a common illuminator, a backlight for a liquid display, or the like.
Here, the "white" means a white region in the CIE-chromaticity chart shown in FIG. 2.

In the light emitting apparatus 1, since the fluorescence medium 20 having a semi-circular cross section is covered by the emitting device 30, the emission spectrum of the emitting device 30 does not vary significantly even though the viewing angle is changed.
Furthermore, due to the configuration shown in FIG. 1, the distance for which the light (x2) emitted from the emitting surface A transmits the fluorescence medium 20 and the distance for which the light (x1) emitted from the emitting surface B transmits the fluorescence medium 20 becomes almost equal (substantially equal). Here, "substantially equal" means that, as for the light rays emitted from two or more emitting surfaces, the ratio of the distance for which the light ray emitted from one emitting surface transmits the fluorescence medium 20 to the distance for which the light rays emitted from other emitting surfaces transmit the fluorescence medium 20 is 0.8 to 1.2. Outside this range, the intensities of light rays from the emitting device after transmitting the fluorescence medium 20 vary significantly. As a result, the view angle dependency may increase (change in chromaticity may exceed 0.01). By causing the distances for which the light rays transmit the fluorescence medium 20 to be substantially equal, the intensity of the light (x2) emitted from the emitting surface A after transmitting the fluorescence medium 20 and the intensity of the light (x1) emitted from the emitting surface B after transmitting the fluorescence medium 20 becomes almost equal.
In addition, since the fluorescence rays (y1, y2) emitted by the fluorescence medium 20 which has been excited by the light emitted by the emitting device 30 have an almost identical spectrum and intensity (i.e. isotropic), light rays (x1 + y1, x2 + y2) obtained by mixing the light rays emitted by the emitting device 30 (x1, x2) (light rays which have transmitted the fluorescence medium) and the fluorescence rays (y1, y2) emitted by the fluorescence medium 20 are only slightly different in spectrum and emission intensity when changing the viewing angle, resulting in a small change in color (less dependent on the viewing angle). As a result, it is possible to obtain a light emitting apparatus which can perform almost uniform plane emission.

As for the fluorescent material in the fluorescence medium 20, both organic fluorescent materials and inorganic fluorescent materials may be used. Nanocrystal fluorescent materials are particularly preferable.
A "nanocrystal fluorescent material" means a fluorescent material composed of nanoparticles (particle size: 1 to about 50 nm). Due to the small particle size, the nanocrystal fluorescent material has a high degree of transparency and suffers from only a small degree of scattering loss, thereby enabling a light emitting apparatus to have an increased luminous efficiency.

The nanocrystal fluorescent material is preferably a semiconductor nanocrystal.
A semiconductor nanocrystal has a large absorption coefficient and a high fluorescent coefficient. As a result, the fluorescence medium can be formed into a thin film, and distortion of the emitting device on the fluorescence medium can be minimized. As a result, a light emitting apparatus suffering from a small amount of defects can be obtained.

The light emitting apparatus 1 as mentioned above is a light emitting apparatus in which light is outcoupled from the supporting substrate (bottom-emission type). In such a bottom-emission type, it is preferred that a reflective layer (a reflective electrode) (not shown) be provided on the side opposite to the supporting substrate 10 of the emitting device 30. For example, a second electrode 33 may serve as a reflective electrode.

In this embodiment, the cross section of the fluorescence medium is semi-circular. However, as exemplified in the following examples, the shape of the fluorescence medium is not limited thereto. The cross section of the fluorescence medium may be semi-circular, trapezoidal or doughnut-like, for example. That is, it suffices that the shape of the cross section of the fluorescence medium has a convex portion. Due to such a shape of the cross section, the emission spectra of light rays which are emitted from the emitting device and transmit the fluorescence medium at two or more different angles can be substantially the same.

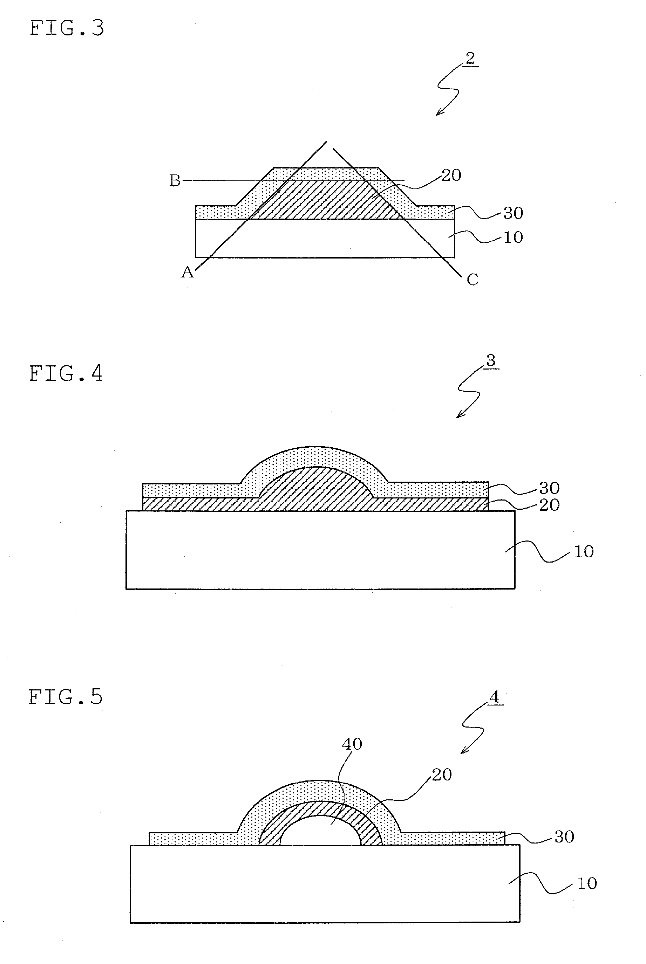

For example, as shown in FIG. 3, the light emitting apparatus 2 has the fluorescence medium 20 with a trapezoidal cross section and has three emitting surfaces A, B and C. Since these emitting surfaces are not parallel to each other, the emission spectra of light rays which are emitted from the emitting device and transmit the fluorescence medium at the three different angles can be substantially the same.

In addition, as shown in FIG. 4, in the light emitting apparatus 3, the fluorescence medium 20 is extended, together with the emitting device 30, in parallel with the surface of the supporting substrate 10. Since part of the fluorescence medium 20 has a semi-circular cross section, the view angle dependency of the light emitting apparatus 3 can be decreased. In addition, since the area occupied by the fluorescence medium 20 is large, the intensity of light emitted by the fluorescence medium 20 can be rendered relatively strong in the emission of the light emitting apparatus, thereby enabling adjustment of emission color.

Furthermore, as shown in FIG. 5, in the light emitting apparatus 4, a convex part 40 with a semi-circular cross section is provided on the supporting substrate 10. The thickness of the fluorescence medium 20 formed on the convex part 40 is substantially uniform.
Here, "substantially uniform" means that the thickness of the fluorescence medium 20 varies within ± 20%. If the variation in the thickness of the fluorescence medium 20 exceeds ± 20%, the variation in the intensity of light rays which have been emitted from the emitting device and have transmitted the fluorescence medium may increase, resulting in an increased view angle dependency (a change in chromaticity exceeds 0.01).

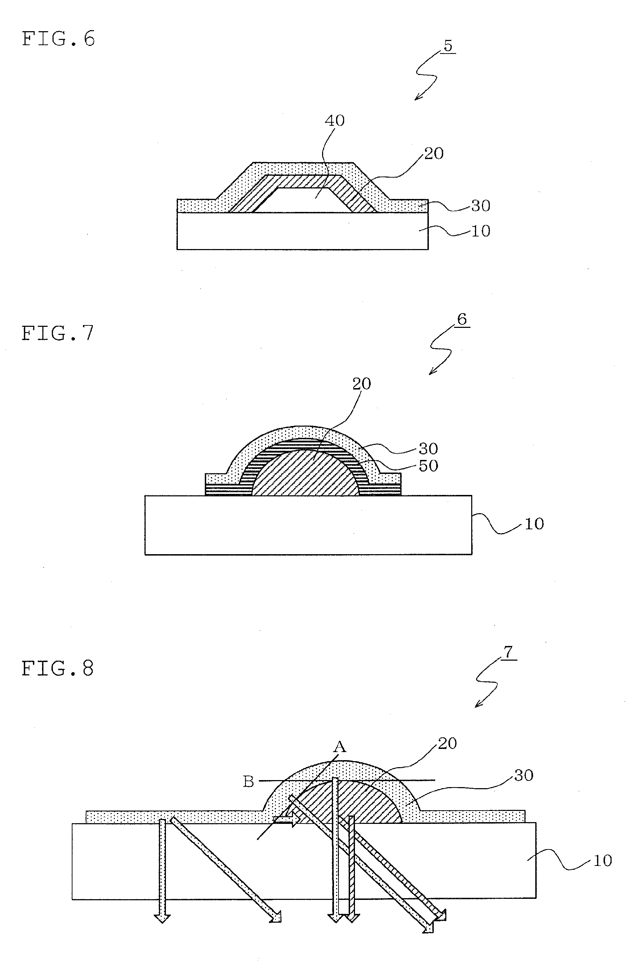

Furthermore, as shown in FIG. 6, in the light emitting apparatus 5, the cross section of each of the convex part 40, the fluorescence medium 20 and the emitting device 30 has a trapezoidal shape. The thickness of the fluorescence medium 20 formed on the convex part 40 is substantially uniform.

In the light emitting apparatuses 4 and 5, it is preferred that the fluorescence medium 20 have a substantially uniform thickness, since not only the emission spectra of light rays which have been emitted from the emitting device 30 and have transmitted the fluorescence medium 20, but also the intensities thereof can be uniform (transmission distance can be uniform).

Furthermore, as shown in FIG. 7, in the light emitting apparatus 6, a transparent barrier layer 50 is provided between the fluorescence medium 20 and the emitting device 30. Provision of the transparent barrier layer 50 is preferable, since deteriorating components such as moisture, oxygen, low-molecular components, which are contained in the fluorescence medium 20, are blocked, resulting in improved durability of the emitting device 30.

In this embodiment, the emitting device is not formed on the supporting substrate on which the fluorescence medium is not formed. However, as exemplified in the following embodiments, the emitting device may be formed on a supporting substrate on which the fluorescence medium is not formed.

FIG. 8 is a cross sectional view of embodiment 2 of a light emitting apparatus according to the first aspect.
As shown in FIG. 8, the light emitting apparatus 7 is different from the light emitting apparatus 1 of embodiment 1 in that the emitting device 30 is formed on the supporting substrate 10 on which the fluorescent medium 20 is not formed. That is, while part of the emitting device 30 covers the fluorescent medium 20, part of the emitting device does not cover the fluorescent medium 20.
Even though the light emitted by the emitting device 30 in the direction of the supporting substrate 10 causes the emission color to be dependent on the viewing angle due to the interference effect of the emitting device 30, the entire viewing angle dependency of the light emitting apparatus 7 is improved since the emitting surface A and the emitting surface B of the emitting device 30 are not parallel to each other (the viewing angle dependency is improved at least as compared with the case where the emitting surfaces are parallel to each other).
Furthermore, part of the light which is entered from the side of the fluorescence medium 20 into the medium 20 is utilized for the light conversion of the fluorescence medium 20 like the light-emitting apparatus 1. However, since the amount of light which is entered from the side is large as compared with the light emitting apparatus 1, the intensity of fluorescence emitted from the fluorescence medium 20 is increased.

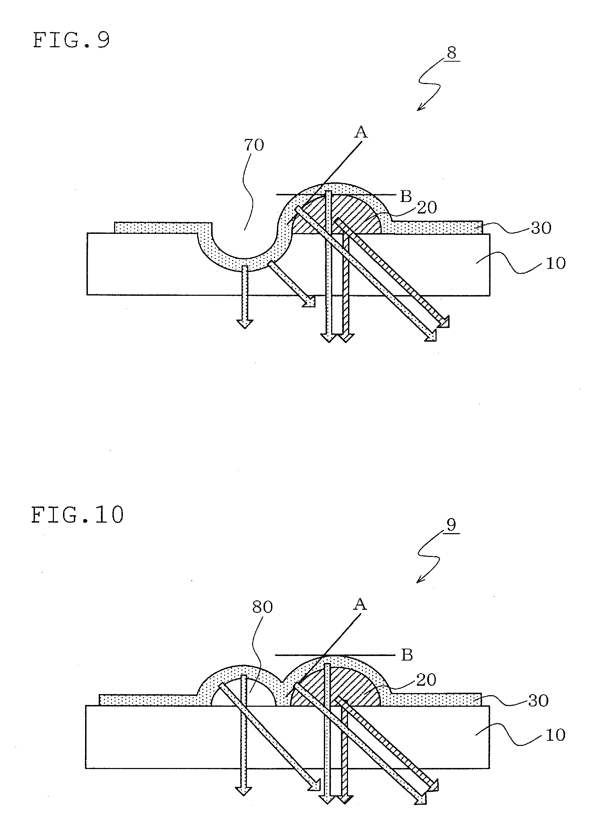

In the light emitting apparatus 8 shown in FIG. 9, a concave part 70 is provided adjacent to the fluorescence medium 20 on the supporting substrate 10. As a result, the emitting device 30 has a concave shape. In this apparatus 8, the emitting device 30 is formed on the concave part 70 on the supporting substrate 10, as well as on the fluorescent medium 20.

Furthermore, in the light emitting apparatus 9 shown in FIG. 10, a convex part 80 is provided in the vicinity of the fluorescence medium 20 on the supporting substrate 10. As a result, the emitting device 30 has a convex shape. In this apparatus 9, the emitting device 30 is formed on the convex part 80 on the supporting substrate 10, as well as on the fluorescence medium 20.

In the light emitting apparatuses 8 and 9, the emission spectrum of the light emitted by the emitting device 30 on the supporting substrate 10 varies slightly when the angle of observation is changed. Therefore, the entire viewing angle dependency of the light emitting apparatuses 8 and 9 is improved as compared with the light emitting apparatus 7.
The light emitting apparatuses in the above-mentioned embodiments are a bottom-emitting type apparatus. However, as exemplified in the following embodiments, the light emitting apparatus may be a top-emitting apparatus in which light is outcoupled in the direction opposing to the supporting substrate (away from the supporting substrate). In the case of a top-emitting light emitting apparatus, it is preferred that a reflective layer be present on the supporting substrate side of the emitting device.

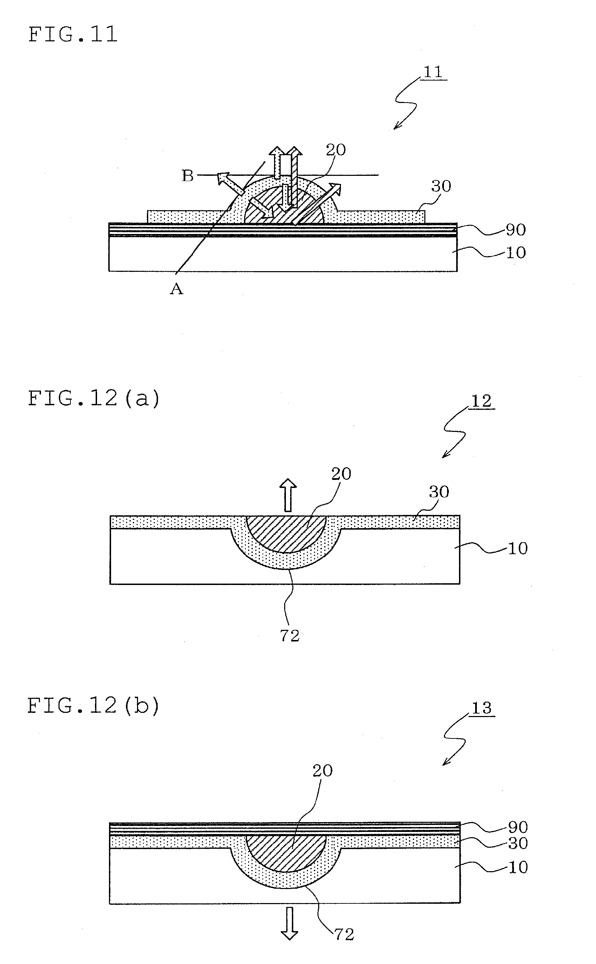

FIG. 11 is a cross sectional view of embodiment 3 of the light emitting apparatus according to the first aspect.
As shown in FIG. 11, the light emitting apparatus 11 in FIG. 11 is different from the light emitting apparatuses of the embodiments 1 and 2 (bottom emission type) in that a reflective layer 90 is provided on the supporting substrate 10 to allow emission from the fluorescence medium 20 and the emitting device 30 to be reflected by the reflective layer 90, and the reflected light is outcoupled in the direction away from the supporting substrate 10 (top emission type).
In the case of such a top-emitting apparatus, the emitting device may be a double-side emitting device.

Since the emitting surface A and the emitting surface B of the emitting device 30 are not parallel to each other, light emitted in the direction away from the supporting substrate 10 becomes isotropic emission of which the spectrum does not vary depending on the angle.
Light emitted in the direction of the supporting substrate 10 from the emitting surfaces A and B excites the fluorescence medium 20 to cause the fluorescence medium 20 to emit fluorescence. The emitted fluorescence is reflected by the reflective layer 90, and then irradiated in the direction away from the supporting substrate 10.
At least the light obtained by mixing the light emitted by the emitting device 30 and the fluorescence emitted by the fluorescence medium 20 is less dependent on the viewing angle as compared with the case where the emitting surface A and the emitting surface B are parallel to each other.
Furthermore, as in the case of a light emitting apparatus 12 illustrated in FIG. 12 (a), a convex part 72 may be provided in the supporting substrate 10 to allow the emitting device 30 and the fluorescence medium 20 to be embedded in this order in the supporting substrate 10 to outcouple light on the side opposing to the supporting substrate 10 (top emission type). In addition, as in the case of a light emitting apparatus 13 illustrated in FIG. 12(b), a both-side emitting device may be used as the emitting device 30 with the reflective layer 90 in the light emitting apparatus 12, thereby outcoupling light in the direction of the supporting substrate 10 (bottom emission type).

In the above-mentioned embodiments, the emitting device is an organic EL device. However, the emitting device is not limited to an organic EL device, and an inorganic EL device, a LED, or the like may be used. However, by using an organic EL device as the emitting device, adjustment of emission spectrum can be performed easily at a low voltage by selecting emitting materials, other materials used therein, device configuration or the like.

The above-mentioned drawings show only the characteristic features of the light emitting apparatus of the invention. The light emitting apparatus of the invention may further contain a sealing member or the like.

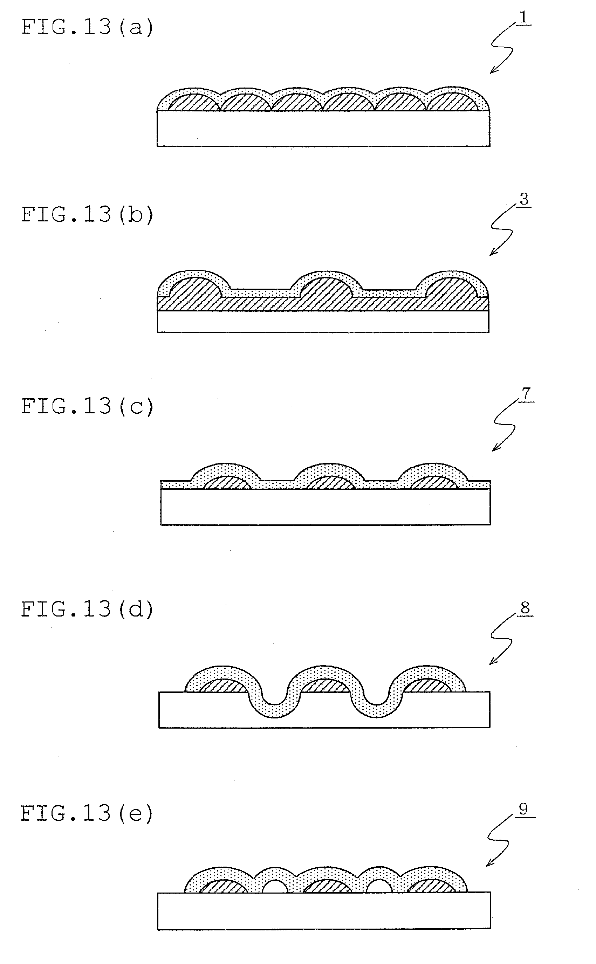

The light emitting apparatus according to the first aspect of the invention contains at least one of the light emitting apparatuses 1 to 9 and 11 to 13 of the embodiments 1 to 3 as a basic unit. Normally, the light emitting apparatus has a configuration in which these base units are repeatedly arranged. FIGs. 13(a) to 13(b) show the examples.
FIG. 13 (a) is a cross sectional view of a light emitting apparatus obtained by using the light emitting apparatus 1 shown in FIG. 1 as a basic unit and continuously arranging the light emitting apparatuses 1.
FIG. 13 (b) is a cross sectional view of a light emitting apparatus obtained by using the light emitting apparatus 3 shown in FIG. 4 as a basic unit and continuously arranging the light emitting apparatuses 3.
FIG. 13 (c) is a cross sectional view of a light emitting apparatus obtained by using the light emitting apparatus 7 shown in FIG. 8 as a basic unit and continuously arranging the light emitting apparatuses 7.
FIG. 13 (d) is a cross sectional view of a light emitting apparatus obtained by using the light emitting apparatus 8 shown in FIG. 9 as a basic unit and continuously arranging the light emitting apparatuses 8.
FIG. 13 (e) is a cross sectional view of a light emitting apparatus obtained by using the light emitting apparatus 9 shown in FIG. 10 as a basic unit and continuously arranging the light emitting apparatuses 9.

Here, the fluorescence medium in each unit may be either the same or different.
Due to the repetitious arrangement of these units, a light emitting apparatus which is less dependent on the viewing angle as a whole can be obtained.

In addition, the above-mentioned light emitting apparatus can have an improved luminance per unit area even though the driving voltage of the light emitting apparatus is limited, since the emission area of the emitting device per unit display area is increased.

The second aspect of the invention will be described below.
The light emitting apparatus according to the second aspect of the invention comprises, on a supporting substrate, an emitting device having two or more emitting surfaces which are not parallel to each other and a fluorescence medium. By forming the emitting device in a convex or concave shape, it is possible to allow the emitting device to have two or more emitting surfaces which are not parallel to each other. The fluorescence medium is provided in a direction different from the direction from which light emitted by the emitting device is outcoupled. Fluorescence media may be provided in two or more directions different from the outcoupling direction. A fluorescence medium may be provided in the outcoupling direction insofar as at least one fluorescence medium is provided in a direction different from the outcoupling direction. The light emitting apparatus emits a mixture of light emitted by the emitting device and fluorescence emitted by the fluorescence medium.

The light emitting apparatus according to the second aspect of the invention will be described in detail with reference to the drawings.

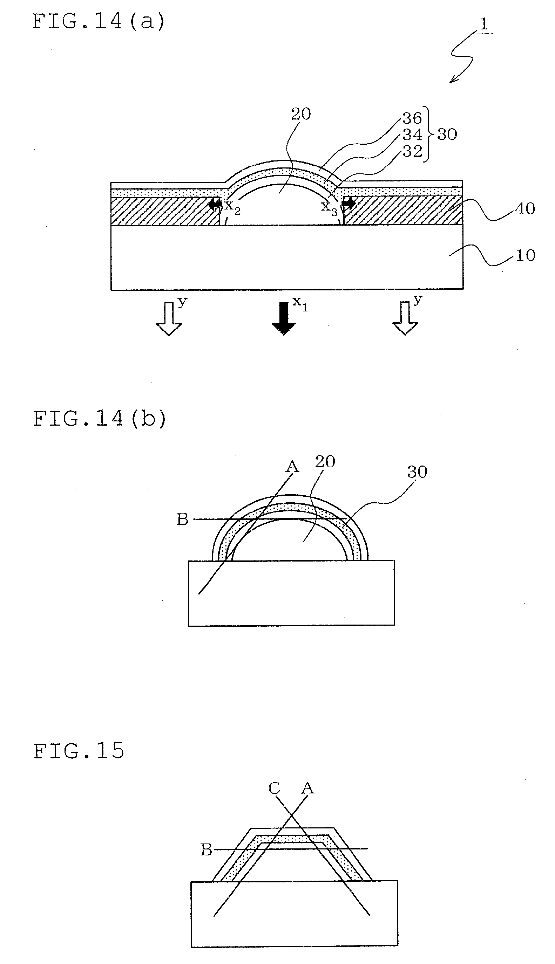

FIG. 14(a) is a cross sectional view of embodiment 1 of the light emitting apparatus according to the second aspect of the invention.
As shown in FIG. 14(a), in the light emitting apparatus 1, a convex part 20 is provided on the supporting substrate 10. An emitting device 30 is provided on the convex part 20 in which a lower electrode 32, a luminescent medium 34 and an upper electrode 36 are stacked in this order. In addition, in the area other than the convex part 20 on the supporting substrate 10, a fluorescence medium 40 is provided.

The surface of the emitting device 30 follows the shape of convex part 20. As shown in FIG. 14 (b), the emitting device 30 has a plurality of emitting surfaces which are not parallel to each other, such as A and B. That is, in this embodiment, the emitting device 30 having emitting surfaces which are not parallel to each other is formed by providing the convex part 20 on the supporting substrate 10.
In the second aspect of the invention, the "emitting surface" means a surface of the emitting device 30 which emits light at a right angle into the convex part 20. When the emitting device 30 is in contact with the convex part 20, the "emitting surface" means the contact surface between the emitting device 30 and the convex part 20.

In this light emitting apparatus 1, the emitting device 30 emits light isotropically. The light x₁ emitted toward the supporting substrate 10 is outcoupled as it is. The light x₂ and x₃ emitted toward the fluorescence medium 40 are converted by the fluorescence medium 40, and the converted light is then emitted isotropically. The converted light y emitted toward the supporting substrate 10 is outcoupled. The light x₁ emitted by the emitting device 30 and the light y emitted by the fluorescence medium 40 (fluorescence) are mixed, and the mixed light is then emitted through the supporting substrate 10. The color of mixed light is preferably white. Since the color of emitted light is white, it is possible to apply the light emitting apparatus to a common illuminator, a backlight for a liquid display, or the like.
Since the emitting device 30 and the fluorescence medium 40 emit light of blue, green and red, it is possible to allow the mixed light to be white. Although there are no specific restrictions on the combination of color of light emitted by the emitting device 30 and color of light emitted by the fluorescence medium 40, it is preferred that the emitting device emit blue-green light and the fluorescence medium emit red light.

In the light emitting apparatus 1 shown in FIG. 14(a), a luminescent medium 34 and an upper electrode 36 are formed in the area other than the convex part 20. However, the luminescent medium 34 and the upper electrode 36 may be provided only on the convex part 20. The lower electrode 32 may be extended over above the supporting substrate. In this case, since an insulating fluorescence medium is between the lower electrode and the upper electrode, the emitting device emits only on the convex part.

As the fluorescent material for the fluorescence medium 40, both organic fluorescent materials and inorganic fluorescent materials may be used. Nanocrystal fluorescent materials are particularly preferable.
A "nanocrystal fluorescent material" means a fluorescent material composed of nanoparticles (particle size: 1 to about 50 nm). Due to the small particle size, the nanocrystal fluorescent material has a high degree of transparency and suffers from only a small scattering loss, thereby enabling a light emitting apparatus to have an increased luminous efficiency.

The nanocrystal fluorescent material is preferably a semiconductor nanocrystal.
A semiconductor nanocrystal has a large absorption coefficient and a high fluorescent efficiency. As a result, the fluorescence medium can be formed into a thin film, and distortion of the emitting device on the fluorescence medium can be minimized. As a result, a light emitting apparatus suffering from a small amount of defects can be obtained.

The light emitting apparatus 1 as mentioned above is a light emitting apparatus in which light (x₁, y) is outcoupled from the supporting substrate (bottom-emitting type). In such a bottom-emitting light emitting apparatus, it is preferred that a reflective layer (not shown) be provided on the side opposite to the supporting substrate 10 of the emitting device 30. Normally, the supporting substrate 10, the lower electrode 32 and the upper electrode 36 are rendered as a transparent substrate, a transparent electrode and a reflective electrode, respectively.

In this embodiment, the cross section of the convex part 20 is semi-circular. For example, the cross section is in a semi-spherical or semi-cylindrical shape with a slightly flattened top. It is preferred that the convex part 20 is semi-spherical.
The shape of the cross section of the convex part 20, i. e. the emitting device, is not limited to semi-circular. For example, it suffices that the shape of the cross section of the emitting device has a convex part, such as a trapezoidal or doughnut-like shape.

For example, as shown in FIG. 15, the cross section of the emitting device 30 has a trapezoidal cross section, and has three emitting surfaces A, B and C. Since these emitting surfaces are not parallel to each other, the emission spectrum of the emitting device may be substantially the same at three different angles.

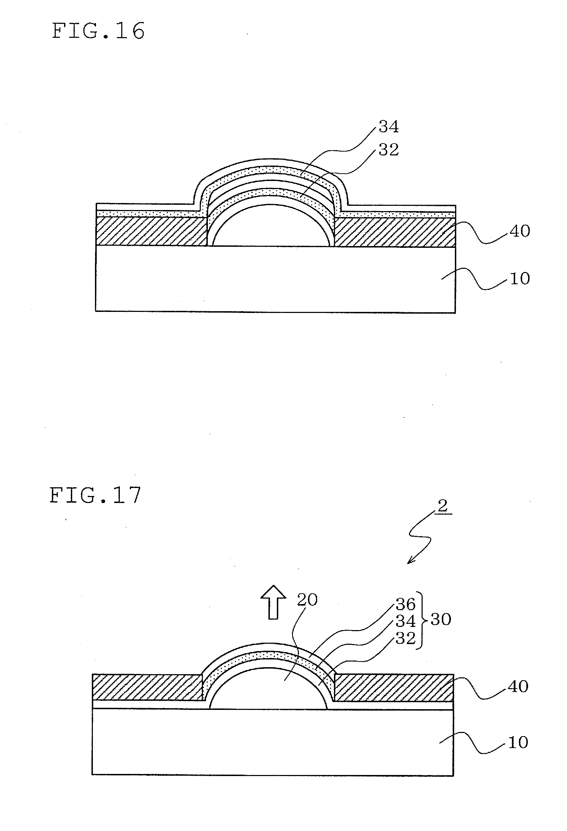

In the light emitting apparatus 1, the emitting device 30 is composed of a single stacked body 30. However, as shown in FIG. 16, the emitting device 30 may be composed of two or more stacked bodies 32 and 34. By allowing the emitting device 30 to be composed of two or more stacked bodies, mixing of two or more emission colors becomes possible. The emitting device 30 may emit light of a single color or two or more colors.

The light emitting apparatus 1 of this embodiment is a bottom-emitting type apparatus. However, as shown in FIG. 17, the light emitting apparatus 1 may be a top-emitting apparatus in which light is outcoupled in the direction away from the supporting substrate 10. In the light emitting apparatus 2 shown in FIG. 17, the lower electrode 32 as a reflective electrode is formed on the supporting substrate 10. The fluorescent medium 40 is formed on the lower electrode 32, and the luminescent medium 34 and the upper electrode 36 are formed thereon, whereby the emitting device 30 is formed. In the case of a top-emission type, the upper electrode 36 is normally a transparent electrode.

In the light emitting apparatus 2 shown in FIG. 17, the luminescent medium 34 and the upper electrode 36 are formed only on the convex part 20. However, the luminescent medium 34 or the upper electrode 36 may be formed also in the area other than the convex part 20.

In the technology of applying a light emitting apparatus to large-area illuminations, it is of importance that an emitting device has both improved viewing angle properties and light outcoupling properties. As in this embodiment, by allowing the emitting surface of the emitting device to be in the shape of a projection, preferably a sphere, viewing angle properties can be improved. In addition, by arranging the fluorescence medium around the projected emitting device, the components which travel in the direction of plane can be utilized.

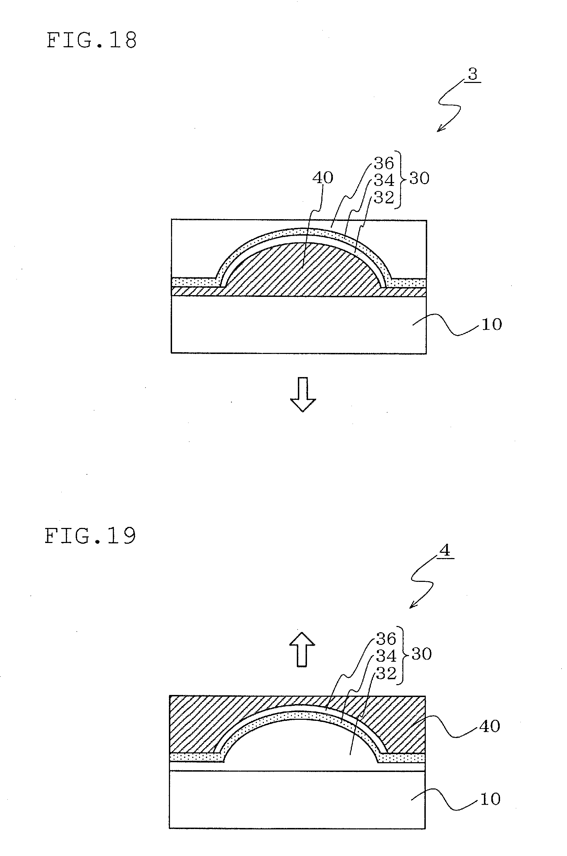

FIG. 18 is a cross sectional view showing embodiment 2 of the light emitting apparatus according to the second aspect of the invention.
In the light emitting apparatus 3, the fluorescence medium 40 is formed in a convex shape, and the emitting device 30 is formed thereon. As a result, the emitting device 30 having emitting surfaces which are not parallel to each other is formed.
In addition, the light emitting apparatus 3 is flattened by the upper electrode 36.

The light emitting apparatus 3 is of bottom-emission type. The light emitting apparatus 4 shown in FIG. 19 is an apparatus obtained by modifying the light emitting apparatus 3 to be of top-emission type.
The light emitting apparatus 4 shown in FIG. 19 differs from the light emitting apparatus of the embodiment 1 in that the emitting device 30 is embedded in the fluorescence medium 40.
In this apparatus, the reflective lower electrode is formed in a convex shape, and the emitting device is formed thereon, whereby the emitting device 30 having emitting surfaces which are not parallel to each other is formed.
As in the case of the above-mentioned light emitting apparatus 4, due to the configuration in which the emitting device is embedded in the fluorescence medium, the fluorescence medium covers the emitting device entirely. As a result, efficiency of the device can be improved as a whole.

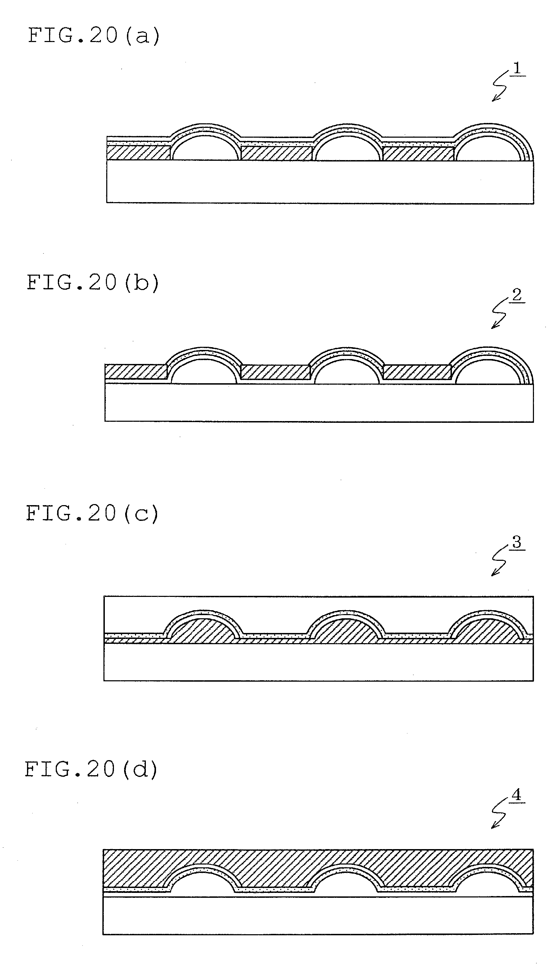

Normally, a light emitting apparatus contains at least one of the light emitting apparatuses 1, 2, 3 and 4 given in the above embodiments as a basic unit and has a configuration in which this basic unit is repeatedly arranged. A specific example is shown in FIG. 20.
FIG. 20 (a) is a cross sectional view of a light emitting apparatus obtained by using the light emitting apparatus 1 shown in FIG. 14(a) as a basic unit and continuously arranging the light emitting apparatuses 1.
FIG. 20 (b) is a cross sectional view of a light emitting apparatus obtained by using the light emitting apparatus 2 shown in FIG. 17 as a basic unit and continuously arranging the light emitting apparatuses 2.
FIG. 20 (c) is a cross sectional view of a light emitting apparatus obtained by using the light emitting apparatus 3 shown in FIG. 18 as a basic unit and continuously arranging the light emitting apparatuses 3.
FIG. 20 (d) is a cross sectional view of a light emitting apparatus obtained by using the light emitting apparatus 4 shown in FIG. 19 as a basic unit and continuously arranging the light emitting apparatuses 4.

Here, the fluorescence medium 20 in each unit may be the same or different.
By the repetitious arrangement of these units, a light emitting apparatus which is less dependent on the viewing angle as a whole can be obtained.

In addition, the above-mentioned light emitting apparatus can have an improved luminance per unit area even though the driving voltage of the light emitting apparatus is limited since the emission area of the emitting device per unit display area is increased.

Each member constituting the luminescent device of the invention is described below.

### 1. Emitting device

As an emitting device, an EL device which can provide plane emission is preferable.
An EL device has a configuration in which an emitting layer is provided between two electrodes. An EL device is a plane emitting device which emits light by applying a voltage across the electrodes. An EL device is divided into an inorganic EL device and an organic EL device. In the invention, it is preferable to use an organic EL device which can be driven at a low voltage and can provide various emission colors by selecting a type of emitting layer.

An organic EL device will be described below.
The basic configuration of an organic EL device is as follows.
First electrode/organic luminescent medium/second electrode
Each member will be explained below.

(1) Organic luminescent medium
   The organic luminescent medium can be defined as a medium including an organic emitting layer which can give EL emission upon the recombination of electrons and holes. The organic luminescent medium may be constructed by stacking the following layers on a first electrode.
   (i) Organic emitting layer
   (ii) Hole-injecting layer/organic emitting layer
   (iii) Organic emitting layer/electron-injecting layer
   (iv) Hole-injecting layer/organic emitting layer/electron-injecting layer
   (v) Organic semiconductor layer/organic emitting layer
   (vi) Organic semiconductor layer/electron barrier layer/organic emitting layer
   (iii) Hole-injecting layer/organic emitting layer/adhesion improving layer
   Of these, the configuration (iv) is preferably generally used due to its higher luminance and excellent durability.

(a) Blue emitting layer
   Normally, a blue emitting layer is composed of a host material and a blue dopant. The host material is preferably a styryl derivative, an anthracene derivative, or an aromatic amine. The styryl derivative is in particular preferably at least one selected from distyryl derivatives, tristyryl derivatives, tetrastyryl derivatives, and styrylamine derivatives. The anthracene derivative is preferably an asymmetric anthracene compound. The aromatic amine is preferably a compound having 2 to 4 nitrogen atoms which are substituted with an aromatic group, and is in particular preferably a compound having 2 to 4 nitrogen atoms which are substituted with an aromatic group, and having at least one alkenyl group. The blue dopant is preferably at least one selected from styrylamines, amine-substituted styryl compounds, amine-substituted condensed aromatic rings and condensed-aromatic-ring containing compounds. The blue dopant may be formed of plural different compounds. Examples of the styrylamines and amine-substituted styryl compounds are compounds represented by formulas [1] and [2], and examples of the condensed-aromatic-ring containing compounds are compounds represented by formula [3].

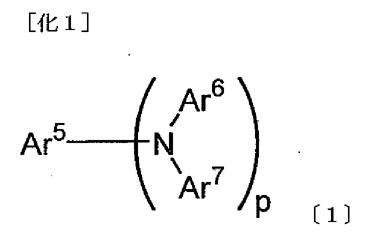

wherein Ar⁵, Ar⁶ and Ar⁷ are independently a substituted or unsubstituted aromatic group having 6 to 40 carbon atoms, at least one of which containing a stryl group; and p is an integer of 1 to 3.

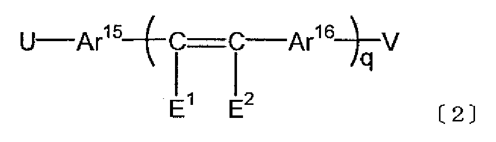

wherein Ar¹⁵ and Ar¹⁶ are independently an arylene group having 6 to 30 carbon atoms, E¹ and E² are independently an aryl or alkyl group having 6 to 30 carbon atoms, a hydrogen atom or a cyano group; q is an integer of 1 to 3. U and/or V is a substituent containing an amino group and the amino group is preferably an arylamino group.

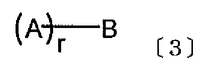

wherein A is an alkyl or alkoxy group having 1 to 16 carbon atoms, a substituted or unsubstituted aryl group having 6 to 30 carbon atoms, a substituted or unsubstituted alkylamino group having 6 to 30 carbon atoms or a substituted or unsubstituted arylamino group having 6 to 30 carbon atoms; B is a condensed aromatic group having 10 to 40 carbon atoms; and r is an integer of 1 to 4.
(b) Green emitting layer
   In order to suppress change in color during continuous lightening, the host material used in a green emitting layer is preferably the same as the host material used in the blue emitting layer.
   As the dopant, it is preferable to use an aromatic amine derivative shown by the following formula [4], in which a substituted anthracene structure and an amine structure substituted by a benzene ring having a substituent are connected.

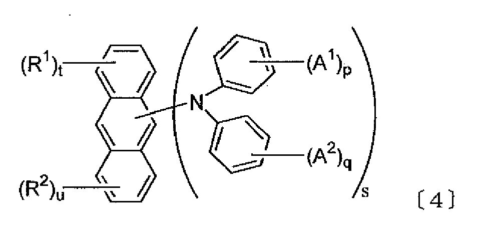

wherein A¹ and A² are independently a hydrogen atom, a substituted or unsubstituted alkyl group having 1 to 10 carbon atoms, a substituted or unsubstituted aryl group having 5 to 50 atoms that form an aromatic ring (ring carbon atoms), a substituted or unsubstituted cycloalkyl group having 3 to 20 ring carbon atoms, a substituted or unsubstituted alkoxyl group having 1 to 10 carbon atoms, a substituted or unsubstituted aryloxy group having 5 to 50 ring carbon atoms, a substituted or unsubstituted arylamino group having 5 to 50 ring carbon atoms, a substituted or unsubstituted alkylamino group having 1 to 10 carbon atoms, or a halogen atom; p and q are each an integer of 1 to 5; and s is an integer of 1 to 9. When p and q are each 2 or more, A¹s and A²s may be the same or different, and may be bonded to each other to form a saturated or unsaturated ring. A¹ and A² cannot be hydrogen atoms at the same time.
R¹ is a substituted or unsubstituted secondary or tertiary alkyl group having 3 to 10 carbon atoms; and t is an integer of 1 to 9. When t is 2 or more, R¹s may be the same or different. R² is a hydrogen atom, a substituted or unsubstituted alkyl group having 1 to 10 carbon atoms, a substituted or unsubstituted aryl group having 5 to 50 ring carbon atoms, a substituted or un substituted arylamino group having 5 to 50 ring carbon atoms, a substituted or unsubstituted cycloalkyl group having 3 to 20 ring carbon atoms, a substituted or unsubstituted alkoxy group having 1 to 10 carbon atoms, a substituted or unsubstituted aryloxy group having 5 to 50 ring carbon atoms, a substituted or unsubstituted arylamino group having 5 to 50 ring carbon atoms, a substituted or unsubstituted alkylamino group having 1 to 10 carbon atoms, or a halogen atom; u is an integer of 0 to 8. When u is 2 or more, R²s may be the same or different. s + t + u is an integer of 2 to 10.

(c) Orange-to-red emitting layer
   In order to suppress change in color during continuous lightening, the host material used in an orange-to-red emitting layer is preferably the same as the host material used in the blue emitting layer.
   As the dopant, a fluorescent compound having at least one fluoranthene skeleton or perylene skeleton, for example, compounds shown by the following formula [5] can be given. 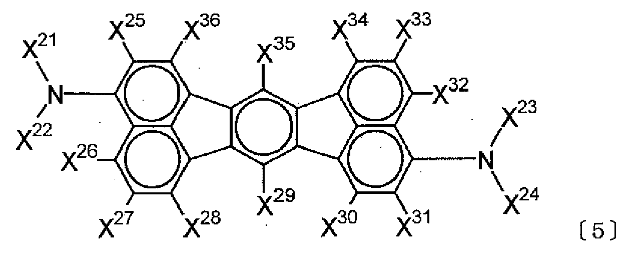 wherein X²¹ to X²⁴ are independently an alkyl group having 1 to 20 carbon atoms, a substituted or unsubstituted aryl group having 6 to 30 carbon atoms; X²¹ and X²² and/or X²³ and X²⁴ may be bonded to each other having a carbon to carbon bond, -O- or -S- therebetween; X²⁵ to X³⁶ are independently a hydrogen atom, a linear, branched or cyclic alkyl group having 1 to 20 carbon atoms, a linear, branched or cyclic alkoxy group having 1 to 20 carbon atoms, a substituted or unsubstituted aryl group having 6 to 30 carbon atoms, a substituted or unsubstituted aryloxy group having 6 to 30 carbon atoms, a substituted or unsubstituted arylamino group having 6 to 30 carbon atoms, a substituted or unsubstituted alkylamino group having 1 to 30 carbon atoms, a substituted or unsubstituted arylalkylamino group having 7 to 30 carbon atoms or a substituted or unsubstituted alkenyl group with 8 to 30 carbon atoms; and adjacent substituents and X²⁵ to X³⁶ may be bonded to each other to form a ring structure. At least one of the substituents X²⁵ to X³⁶ in each of the formulas preferably contains an amine or alkenyl group.

The thickness of the blue emitting layer is preferably 5 to 30 nm, more preferably 5 to 20 nm. When it is less than 5 nm, the formation of an emitting layer and the adjustment of chromaticity may become difficult. When it exceeds 30 nm, the driving voltage may increase.
The thickness of the green emitting layer is preferably 5 to 30 nm, more preferably 5 to 20 nm. When it is less than 5 nm, the luminous efficiency may decrease. When it exceeds 30 nm, the driving voltage may increase.
The thickness of the orange-to-red emitting layer is preferably 5 to 40 nm, more preferably 10 to 30 nm. When it is less than 5 nm, the luminous efficiency may decrease. When it exceeds 30 nm, the driving voltage may increase.

(d) Hole-injecting layer
   It is preferable to use a compound having a hole mobility of 1 × 10⁻⁶ cm²/V·sec or more measured when applying a voltage of 1 × 10⁴ to 1 × 10⁶ V/cm and an ionization energy of 5.5 eV or less for the hole-injecting layer of the organic luminescent medium. Holes are reliably injected into the emitting layer by providing such a hole-injecting layer, whereby a high luminance is obtained, or the device can be driven at a low voltage.

Specific examples of the material constituting the hole-injecting layer include organic compounds such as porphyrin compounds, aromatic tertiary amine compounds, styrylamine compounds, aromatic dimethylidene type compounds, condensed aromatic ring compounds such as 4,4'-bis(N-(1-naphthyl)-N-phenylamino)biphenyl (hereinafter abbreviated as "NPD") and 4,4',4"-tris(N-(3-methylphenyl)-N-phenylamino)triphenylamin e (hereinafter abbreviated as "MTDATA").
In addition, as the material constituting the hole-injecting layer, inorganic compounds such as p-type Si and p-type SiC can also be used. In the meantime, it is preferable to provide an organic semiconductor layer having an electric conductivity of 1 × 10⁻¹⁰ S/cm or more between the above-mentioned hole-injecting layer and the anode layer, or between the hole-injecting layer and the organic emitting layer. Due to the provision of the organic semiconductor layer, hole can be injected more reliably to the organic emitting layer.

(e) Hole-transporting layer
As the material for the hole-transporting layer, the above-mentioned materials may be used. In addition, the following can also be used: porphyrin compounds (disclosed in JP-A-63-2956965 and others), aromatic tertiary amine compounds and styrylamine compounds (see USP No. 4, 127, 412, JP-A-53-27033, 54-58445, 54-149634, 54-64299, 55-79450, 55-144250, 56-119132, 61-295558, 61-98353 and 63-295695, and others), and aromatic tertiary amine compounds. The following can also be given as examples: 4,4'-bis(N-(1-naphthyl)-N-phenylamino)biphenyl, which has in the molecule thereof two condensed aromatic rings, disclosed in USP No. 5,061,569, and 4,4',4"-tris(N-(3-methylphenyl)-N-phenylamino)triphenylamin e, wherein three triphenylamine units are linked to each other in a star-burst form, disclosed in JP-A-4-308688. Aromatic dimethylidene type compounds, mentioned above as the material for the emitting layer, and inorganic compounds such as p-type Si and p-type SiC can also be used as the material of the hole-injecting layer or the hole-transporting layer.

This hole-transporting layer may be a single layer made of one or two or more of the above-mentioned materials, or may be stacked hole-transporting layers or hole-transporting layers made of different compounds. The thickness of the hole-injecting layer or the hole-transporting layer is not particularly limited, and is preferably 20 to 200 nm.

(f) Organic semiconductor layer
   The organic semiconductor layer is a layer for helping the injection of holes or electrons into the emitting layer, and is preferably a layer having an electric conductivity of 10⁻¹⁰ S/cm or more. As the material of such an organic semiconductor layer, electroconductive oligomers such as thiophene-containing oligomers or arylamine-containing oligomers disclosed in JP-A-8-193191, and electroconductive dendrimers such as arylamine-containing dendrimers may be used. Although there are no particular restrictions on the thickness of the organic semiconductor layer, the thickness of the organic semiconductor layer is preferably 10 to 1000 nm.

(g) Electron-transporting layer
   An electron-transporting layer or the like may be provided between the cathode and the orange-to-red emitting layer. The electron-transporting layer is a layer for helping the injection of electrons into the emitting layer, and has a large electron mobility. An electron-transporting layer is formed to control energy level, for example, to reduce precipitous energy level changes. The material used in the electron-transporting layer is preferably a metal complex of 8-hydroxyquinoline or a derivative thereof. Specific examples of the metal complexes of 8-hydroxyquinoline or derivatives thereof include metal chelate oxynoid compounds containing a chelate of oxine (generally, 8-quinolinol or 8-hydroxyquinoline). For example, tris 8-quinolinol) aluminum can be used. An electron-transporting compound of the following general formulas [6] to [8] can be given as the oxadiazole derivative. 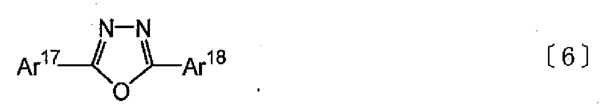 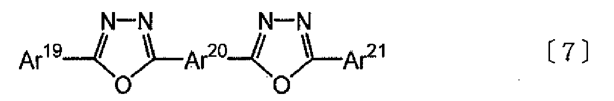 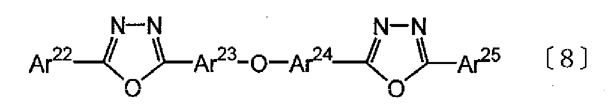 wherein Ar¹⁷, Ar¹⁸, Ar¹⁹, Ar²¹, Ar²² and Ar²⁵ are independently a substituted or unsubstituted aryl group, and Ar¹⁷ and Ar¹⁸, Ar¹⁹ and Ar²¹ and Ar²² and Ar²⁵ may be the same or different; Ar²⁰, Ar²³ and Ar²⁴ are independently a substituted or unsubstituted arylene group, and Ar²³ and Ar²⁴ may the same or different.

Examples of the aryl group in the general formulas [6] to [8] include phenyl, biphenyl, anthranyl, perylenyl, and pyrenyl groups. Examples of the arylene group include phenylene, naphthylene, biphenylene, anthranylene, perylenylene, and pyrenylene groups. Examples of the substituents for these include alkyl groups with 1 to 10 carbon atoms, alkoxy groups with 1 to 10 carbon atoms, and a cyano group. The electron-transporting compounds are preferably ones from which a thin film can be easily formed. Specific examples of the electron transporting compounds are mentioned below. 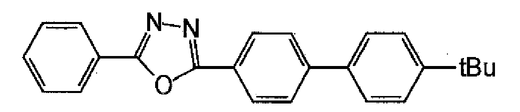 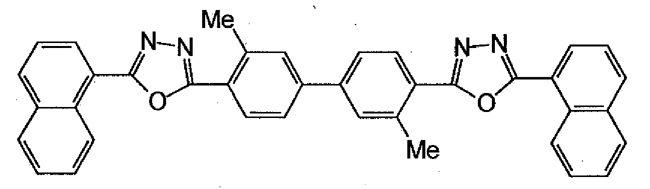 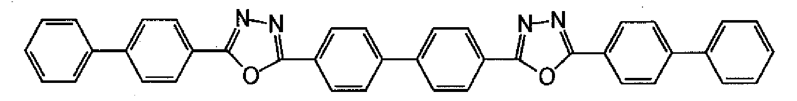 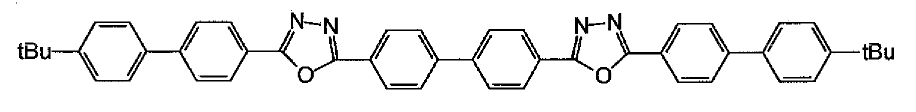 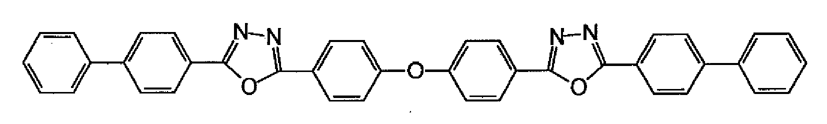 In the above formula, Me indicates a methyl group and tBu indicates a t-butyl group.
The thickness of the electron injecting layer or the electron transporting layer is preferably 1 to 100 nm, although the thickness is not limited thereto.

It is also preferable that the blue-emitting layer, the hole-transporting layer or the hole-injecting layer which is the organic layer closest to the anode contain an oxidizing agent. Preferable oxidizing agents to be contained in the emitting layer, the hole-transporting layer or the hole-injecting layer are an electron-attractive acceptor or an electron acceptor. Preferred are Lewis acids, various quinone derivatives, dicyanoquinodimethane derivatives, or salts formed by an aromatic amine and Lewis acid. Particularly preferable Lewis acids are iron chloride, antimony chloride, aluminum chloride or the like.

It is also preferable that the yellow-to-red emitting layer, the electron-transporting layer or the electron-injecting layer which is the organic layer closest to the cathode contain a reducing agent. Preferable reducing agents are alkali metals, alkaline earth metals, oxides of alkali metals, oxides of alkaline earth metals, oxides of rare earth metals, halides of alkali metals, halides of alkaline earth metals, halides of rare earth metals, and complexes formed of alkali metals and aromatic compounds. Particularly preferred alkali metals are Cs, Li, Na and K.

(h) Inorganic compound layer
   An inorganic compound layer may be provided in contact with the anode and/or the cathode. The inorganic compound layer functions as an adhesion-improving layer. As a preferable inorganic compound to be used in the inorganic compound layer include alkali metal oxides, alkaline earth metal oxides, rare earth metal oxides, alkali metal halides, alkaline earth metal halides, rare earth metal halides, various oxides, nitrides and oxidized nitrides such as SiOₓ, AlOₓ, SiNₓ, SiON, AlON, GeOₓ, LiOₓ, LiON, TiOₓ, TiON, TaOₓ, TaON, TaNₓ and C. In particular, as the components of the layer which is in contact with the anode, SiOₓ, AlOₓ, SiNₓ, SiON, AlON, GeOₓ and C are preferable since they forma stable injection interface layer. As the components of the layer which is in contact with the cathode, LiF, MgF₂, CaF₂, MgF₂ and NaF are preferable. The thickness of the inorganic compound layer is not particularly limited, but preferably 0.1 to 100 nm.

Although there are no particular restrictions on the method for forming each organic layer containing the emitting layer and the inorganic compound layer, known methods such as the vapor deposition method, the spin coating method, the casing method and the LB method may be used, for example. In addition, it is preferred that the electron-injecting layer and the emitting layer be formed by the same method since the properties of the resulting organic EL device can be uniform and the production time can be shortened. For example, if the electron-injecting layer is formed by the vapor deposition method, it is preferable to form the emitting layer also by the vapor deposition method.

(i) Electron-injecting layer
   It is preferable to use a compound having an electron mobility of 1 × 10⁻⁶ cm²/V·sec or more measured when applying a voltage of 1 × 10⁴ to 1 × 10⁶ V/cm and an ionization energy of more than 5.5 eV for the electron-injecting layer of the organic luminescent medium. Electrons are reliably injected into the organic emitting layer by providing such an electron-inj ecting layer, whereby a high luminance is obtained, or the device can be driven at a low voltage. As specific examples of the material for the electron-injecting layer, a metal complex (Al chelate: Alq) of 8-hydroxyquinoline or its derivative or an oxadiazole derivative can be given.

(j) Adhesion-improving layer
   The adhesion-improving layer in the organic luminescent medium can be regarded as one form of the above-mentioned electron-injecting layer. Specifically, the adhesion-improving layer is an electron-inj ecting layer formed of a material exhibiting excellent adhesion to a cathode, and is preferably formed of a metal complex of 8-hydroxyquinoline, its derivative, or the like. It is also preferable to provide an organic semiconductor layer with a conductivity of 1 × 10^{-l0} S/cm or more adjacent to the electron-injecting layer. Electrons are more reliably injected into the emitting layer by providing such an organic semiconductor layer.

The thickness of the organic luminescent medium is preferably 5 nm to 5 µm. If the thickness thereof is less than 5 nm, luminance and durability may be decreased. If the thickness of the organic luminescent medium exceeds 5 µm, a applied voltage may be higher. The thickness of the organic emitting layer is more preferably 10 nm to 3 µm, and still more preferably 20 nm to 1 µm.

(2) First or second electrode
   If the first electrode or the second electrode is used as the anode, a metal having a work function which is required for the injection of holes is used. The work function is desirably 4.6 eV or more. Specific examples include a metal such as gold, silver, copper, iridium, molybdenum, niobium, nickel, osmium, palladium, platinum, ruthenium, tantalum, tungsten and aluminum, alloys of these metals, metal oxides such as oxides of indium and/or tin (hereinafter abbreviated as ITO) , oxides of indium and/or zinc (hereinafter abbreviated as IZO), copper iodide, conductive polymers such as polypyrrole, polyaniline, and poly(3-methylthiophene) and a stacked body thereof.

If the second electrode or the first electrode is used as the cathode, a metal having a small work function (4 eV or less), an alloy, an electroconductive compound or a mixture thereof are used as an electrode material. As the specific examples of such an electrode substance, one or two or more of sodium, sodium-potassium alloy, magnesium, lithium, magnesium/silver alloy, aluminum/aluminum oxide, aluminum/lithium alloy, indium, and rare earth metals can be given.

The thickness of each electrode is 5 to 1000 nm, preferably 10 to 500 nm. The thickness of the layer having a low work function is set within the range of 1 to 100 nm, preferably 5 to 50 nm, more preferably 5 to 30 nm. As for the thickness of each electrode and the layer having a low work function, a thickness exceeding the upper limit is not preferable since highly efficient outcoupling of emission from the organic emitting layer cannot be attained. A thickness less than the lower limit is also not preferable since conductivity significantly lowers.
Each layer of the organic EL device can be formed by a known method, such as the vapor deposition method, the sputtering method, the spin coating method or the like.

2. Supporting substrate
The substrate in the light emitting apparatus of the invention (occasionally referred to as "supporting substrate") is a member for supporting the emitting device, the fluorescence layer and the like. The substrate is thus desired to be excellent in mechanical strength and dimension stability.
As such a substrate, a substrate formed of an inorganic substance can be given, examples of which include glass plates, metal plates, and ceramics plates. Preferable inorganic materials include glass materials, silicon oxide, aluminum oxide, titanium oxide, yttrium oxide, germanium oxide, zinc oxide, magnesium oxide, calcium oxide, strontium oxide, barium oxide, lead oxide, sodium oxide, zirconium oxide, sodium oxide, lithium oxide, boron oxide, silicon nitride, silicon nitride, soda-lime glass, barium-strontium-containing glass, lead glass, aluminisilicate glass, borosilicate glass and barium borosilicate glass.
As preferable organic substances for constituting the substrate, polycarbonate resins, acrylic resins, vinyl chloride resins, polyethylene terephthalate resins, polyimide resins, polyester resins, epoxy resins, phenol resins, silicon resins, and fluororesins, polyvinyl alcohol-based resins, polyvinylpyrrolidone resins, polyurethane resins, epoxy resins, cynate resins, melamine resins, maleic resins, vinyl acetate resins, polyacetal resins, cellulose resins or the like can be given.

It is preferable that the supporting substrate formed of such a material be subjected to a moisture-proof treatment or hydrophobic treatment by forming an inorganic film or applying a fluororesin in order to prevent water from entering the organic EL display.
This treatment is particularly effective when organic materials such as a polymer are used.
In addition, in order to prevent moisture from intermixing with the organic luminescent medium, it is preferred that the water content and the gas transmission coefficient of the substrate be small. Specifically, it is preferable to adjust the water content and the gas transmission coefficient of the supporting substrate to 0.0001 wt% or less and 1 × 10⁻¹³ cc·cm/cm²·sec·cmHg or less, respectively.
Of the above-mentioned substrate materials, if EL emission is outcoupled through the supporting substrate (including the case where the substrate is used as a sealing member), it is preferable to use a substrate material having a transmittance for a light with a wavelength of 400 to 700 nm of 70% or more.

3. Fluorescence medium
   The fluorescence medium is a medium which emits light with a longer wavelength (fluorescence) when it receives light emitted by the organic EL device.
   The fluorescence medium contains a fluorescent material, or a fluorescent material and a matrix resin.

Fluorescent materials include inorganic fluorescent materials and organic fluorescent materials.
(1) Inorganic fluorescent material
   As the inorganic fluorescent material, it is possible to use an inorganic fluorescent material which is composed of an inorganic compound such as a metal compound and absorbs visible light and emits fluorescence which has a wavelength longer than that of the absorbed light. Nanocrystal fluorescent materials having a high degree of transparency and suffering from a small degree of scattering loss are preferable. In order to improve the dispersibility in a matrix resin, which will be mentioned later, the surface of the nanocrystal fluorescent material may be modified with an organic substance such as a long-chain alkyl group or phosphoric acid.
   Specifically, the following nanocrystal fluorescent materials may be used.

(a) Nanocrystal fluorescent material obtained by doping a metal oxide with a transition metal ion
   Examples of the nanocrystal fluorescent material obtained by doping a metal oxide with a transition metal ion include those obtained by doping a metal oxide such as Y₂O₃, Gd₂O₃, ZnO, Y₃Al₅O₁₂ and Zn₂SiO₄ with a transition metal ion which absorbs visible light such as Eu²⁺, Eu³⁺, Ce³⁺ and Tb³⁺.

(b) Nanocrystal fluorescent material obtained by doping a metal calcogenide with a transition metal ion
   Examples of the nanocrystal fluorescent material obtained by doping a metal calcogenide with a transition metal ion include those obtained by doping a metal calcogenide such as ZnS, CdS and CdSe with a transition metal ion which absorbs visible light such as Eu²⁺, Eu³⁺, Ce³⁺ and Tb³⁺. In order to prevent S, Se or the like from being withdrawn from reactive components in a matrix resin, which will be mentioned later, the surface may be modified with a metal oxide such as silica or an organic substance.

(c) Nanocrystal fluorescent material which absorbs visible light and emits light utilizing the band gap of a semiconductor (semiconductor nanocrystals)
   As the semiconductor nanocrystals, CdS, CdSe, CdTe, ZnS, ZnSe, InP or the like can be given, for example. As is apparent from JP-A-2002-510866 or other documents, the semiconductor nanocrystals are capable of controlling the band gap due to a small nano particle size, whereby the absorption-fluorescence wavelength can be changed. In order to prevent S, Se or the like from being withdrawn from reactive components in a matrix resin, which will be mentioned later, the surface may be modified with a metal oxide such as silica or an organic substance.

For example, the surface of CdSe nanocrystal fluorescent material may be covered by a shell of a semiconductor substance which has a higher band gap energy such as ZnS. This allows electrons generated within the central fine particle to be confined easily.
The above-mentioned nanocrystal fluorescent materials may be used singly or in combination of two or more.
These semiconductor nanocrystals have a high absorption coefficient and a high fluorescent efficiency. Therefore, they can allow the fluorescence medium to be thin, and the distortion of the emitting device on the fluorescence medium can be minimized. As a result, it is possible to obtain a light emitting apparatus which suffers only a small amount of defects.

(2) Organic fluorescent material
   Specific examples of the organic fluorescent material include 1,4-bis(2-methylstryl)benzene (hereinafter referred to as "Bis-MSB"), stilbene-based pigments such as trans-4,4'-diphenylstilbene (hereinafter referred to as "DPS"), cumarin-based pigments such as 7-hydroxy-4-methylcumarin (hereinafter referred to as "cumarin 4", 2,3,5,6-1H,4H-tetrahydro-8-trifluoromethylquinolidino(9,9a, 1-gh) cumarin (hereinafter referred to as "cumarin 153"), 3-(2'-benzthiazolyl)-7-diethylaminocumarin (hereinafter referred to as "cumarin 6") and 3-(2'-benzimidazolyl)-7-N,N-diethylaminocumarin (hereinafter referred to as ("cumarin 7"), cumarin pigment-based dyes such as basic yellow 51, naphthalimide pigments such as solvent yellow 11 and solvent yellow 116, and perylene-based pigments.

In addition, cyanine-based pigments such as 4-dicyanomethylene-2-methyl-6-(p-dimethylaminostylyl)-4H-py ran (hereinafter referred to as "DCM"), pyridine-based pigments such as 1-ethyl-2-(4-(p-dimethylaminophenyl)-1,3-butadienyl)-pyridi nium-perchlorate (hereinafter referred to as "pyridine 1"), rhodamine-based pigments such as rhodamine B and rhodamine 6G and oxadine-based pigments can also be used.
Furthermore, various dyes (direct dyes, acidic dyes, basic dyes, dispersion dyes, and the like) can be selected insofar as they have fluorescent properties.

It is also possible to use pigments obtained by kneading in advance the above-mentioned fluorescent dyes in a pigment resin such as polymethacrylic acid esters, polyvinyl chloride, vinyl chloride-vinyl acetate copolymers, alkyd resins, aromatic sulfoneamide resins, urea resins, melamine resins and benzoguanamine resins.
These fluorescent dyes or pigments may be used singly or in combination of two or more.

In the fluorescent medium of the light emitting apparatus of the invention, it is particularly preferred that a perylene-based pigment be contained. Perylene-based pigments have excellent fluorescent properties and have high light resistance. In addition, perylene-based pigments do not contain a highly reactive unsaturated bond within the molecule, and hence, it is affected only slightly by the circumference of the matrix resin. As a result, perylene-based pigments can suppress un-uniform deterioration (burning) of the light emitting apparatus, whereby a fluorescence medium which has a high conversion efficiency and high durability can be obtained.
Compounds shown by the following formulas (I) to (III) can be given as the specific examples of the perylene-based pigments.

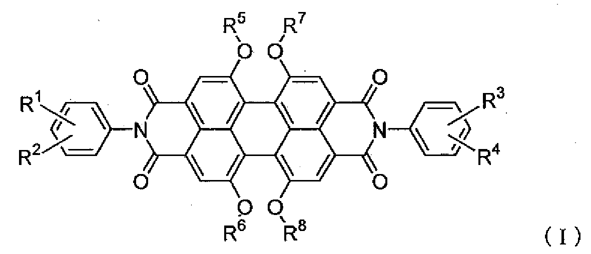

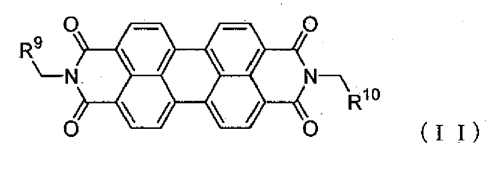

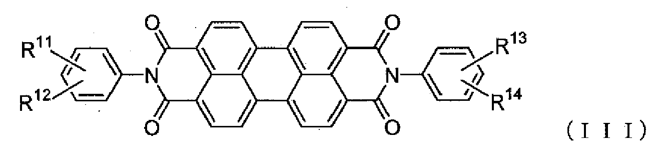

wherein R¹ to R⁴ are independently hydrogen, a straight-chain alkyl group, a branched alkyl group or a cycloalkyl group, and may be substituted; R⁵ to R⁸ are independently a phenyl group, a heteroaromatic group, a straight-chain alkyl group or a branched alkyl group, and may be substituted; R⁹ and R¹⁰ are independently hydrogen, a straight-chain alkyl group, a branched alkyl group or a cycloalkyl group, and may be substituted; and R¹¹ to R¹⁴ are independently hydrogen, a straight-chain alkyl group, a branched alkyl group or a cycloalkyl group, and may be substituted.

(3) Matrix resin
   A matrix resin is a resin in which a fluorescent material is dispersed. As the matrix resin, a non-curable resin, a heat-curable resin or a light-curable resin can be used. Specific examples include melamine resins, phenol resins, alkyd resins, epoxy resins, polyurethane resins, maleic acid resin and polyamide-based resins in the form of an oligomer or a polymer, polymethyl methacrylate, polyacrylate, polycarbonate, polyvinyl alcohol, polyvinylpyrrolidone, hydroxyethyl cellulose, carboxymethyl cellulose, and copolymers composed of monomers which form these.

Furthermore, a light-curable resin may be used. As the light-curable resin, a photopolymerizable type acrylic or methacrylic resin having a reactive vinyl group or a photocrosslinkable type resin such as vinyl polycinnamate, which normally contain a photosensitizer, can be used.
These matrix resins may be used either singly or in a mixture of two or more.

The fluorescence medium can be prepared by using a dispersion obtained by mixing and dispersing a fluorescent material and a matrix resin by a known method such as the milling method and the ultrasonic dispersion method. In this case, a good solvent for the matrix resin can be used. Using this dispersion, a fluorescence medium is formed on the supporting substrate by a known film-forming method such as the photolithographic method, the screen printing method, the inkjet method.
The thickness of the fluorescence medium is 0.1 µm to 1 mm, preferably 0.5 µm to 500 µm, and more preferably 1 µm to 100 µm.

The material and the particle size of the fluorescent material, as well as the mixing ratio of the fluorescent material and the matrix resin vary in an optimized way according to the emission of the organic EL device.

4. Transparent barrier layer
   A transparent barrier layer is provided to prevent the light emitting apparatus, in particular the organic EL device, from being deteriorated by intermixing of moisture, oxygen and a low-molecular components such as a monomer. A preferable transparent barrier layer is a film of an inorganic oxide, an inorganic nitride or an inorganic acid nitride.
   Specific examples include SiOₓ, SiNₓ, SiOₓNy, AlOₓ, TiOₓ, TaOₓ, ZnOₓ, ZrOₓ, CeOₓ and ZrSiOₓ (wherein x is 0.1 to 2 and y is 0.5 to 1.3).
   The thickness of the transparent barrier layer is preferably 1 nm to 10 µm, more preferably 10 nm to 5 µm. If the thickness is less than 1 nm, barrier properties may be insufficient. A thickness exceeding 10 µm, cracking may occur due to an increased internal stress.
   Visible light transmission is preferably 50% or more, more preferably 70% or more, and further preferably 80%.
   This film can be formed by electron beam deposition, sputtering, ion plating or by other methods.

5. Reflective layer
   As the reflective layer, it is preferable to use a layer with a high visible ray reflectance. For instance, a film of Ag, Al, Mg, Au, Cu, Fe, In, Ni, Pb, Pt, W or Zn or an alloy thereof is preferable. In particular, a film of Ag, Al or Mg or an alloy thereof is more preferable since it has a visible ray reflectance of about 80% or more.
   The thickness of the reflective layer is preferably 1 nm to 10 µm, more preferably 10 nm to 5 µm. If the thickness is less than 1 nm, the uniformity of the film may be insufficient. A thickness exceeding 10 µm, cracking may occur due to an increased internal stress.
   This film can be formed by electron beam deposition, resistance heating deposition, sputtering, ion plating or by other methods.

6. Convex part
   The convex part is preferably composed of a transparent material such as a UV-curable resin and a heat-curable resin. The material for the supporting substrate or the matrix resin material of the fluorescence medium is selected.
   Normally, these materials are dispersed in an appropriate solvent to form ink. The thus formed ink is applied to the supporting substrate by the photolithographic method, the screen printing method, the inkjet method or other methods to form a precursor pattern of the convex part, followed by baking to cure, whereby the convex part is formed.

7. Others
   In the thus obtained light emitting apparatus, a light-diffusing layer or a luminance-improving film may be provided on the outermost part of the outcoupling side. Due to the provision of the layer or film as mentioned above, light outcoupling efficiency or in-plane emission uniformity can be further improved.

### EXAMPLES

### Preparation Example 1

### Preparation of a semiconductor nanocrystal fluorescence medium material 1

0.5 g of cadmium acetate dehydrate and 1.6 g of tetradecylphosphonic acid (TDPA) were added to 5 ml of trioctylphosphine (TOP). Under nitrogen atmosphere, the resulting solution was heated to 230°C, and stirred for one hour. After cooling to 60°C, 2 ml of a TOP solution containing 0.2g of selenium was added, whereby a raw material solution was obtained.
10 g of trioctylphophine oxide (TOPO) was put in a three neck flask, and vacuum-dried at 195°C for one hour. The pressure was raised to atmospheric pressure with a nitrogen gas. The flask was then heated at 270°C in the nitrogen atmosphere. While stirring the system, 1.5 ml of the above-obtained raw material solution was added. The reaction (core growth reaction) was allowed to proceed while occasionally checking the fluorescent spectrum of the reaction solution. When the nanocrystal had a fluorescence peak at 615 nm, the reaction solution was cooled to 60°C to terminate the reaction.
Then, 20 ml of butanol was added to cause the semiconductor nanocrystals (core) to precipitate, and separated by centrifugation. The separated nanocrytals were dried under reduced pressure.
5 g of TOPO was put in a three neck flask, and vacuum-dried at 195°C for one hour. The pressure was raised to atmospheric pressure with a nitrogen gas. The flask was cooled to 60°C in the nitrogen atmosphere. Then, 0.05 g of the above-mentioned semiconductor nanocrystals (core) which had been suspended in 0.5 ml of TOP and 0.5 ml of hexane was added. The resulting mixture was stirred for one hour at 100°C under reduced pressure, and then heated to 160°C. The pressure was raised to atmospheric pressure by a nitrogen gas (Solution A).
Solution B which had been prepared separately (prepared by dissolving 0.7 ml of a 1N n-hexane solution of diethyl zinc and 0.13 g of bis(trimethylsilyl)sulfide in 3 ml of TOP) was added dropwise to solution A, which was maintained at 160°C, for 30 minutes. After cooling to 90°C, stirring was continued for a further 2 hours. After cooling to 60°C, 20 ml of butanol was added to cause the semiconductor nanocrystals (core: CdSe/shell: ZnS) to precipitate, and separated by centrifugation. The separated semiconductor nanocrystals were dried under reduced pressure.
The resulting semiconductor nanocrystals were dispersed in a urethane-based heat-curable resin (MIG2500 manufactured by Jujo Chemical Co., Ltd.) as a matrix resin such that the concentration per solid matter of the semiconductor nanocrystals become 9 wt% (volume ratio: 2 vol%) , whereby a red fluorescence medium material 1 using the semiconductor nanocrystals ((CdSe)ZnS) was prepared.

### Preparation Example 2

### Preparation of a semiconductor nanocrystal fluorescence medium material 2

In order to synthesize indium phosphate (InP) semiconductor nanocrystals, 0.02 g (0.1 mmol) of fresh In(OH)₃ was dissolved in 0. 5 g (3 mmol) of HPA and 3.5 g of TOPO at about 200°C under argon stream. The resulting solution was then cooled to 120 to 130°C, and argon was flown into the reaction system. After reducing the pressure for 20 to 30 minutes, argon was further flown for 10 to 15 minutes. The above-mentioned procedure of argon flow and pressure reduction was repeated three times to remove all of the water and the oxygen which had been absorbed in the reaction system. After heating the reaction mixture to 300°C, 2 g of a stock solution containing 0. 0277 g (0.1 mmol) of P(TMS)₃, 1.8 g of TOP and 0.2 g of toluene was poured. The reaction mixture was then cooled to 250°C to allow the nanocrystals to grow. After the nanocrystals grew to a desired particle size, a mantle heater was quickly dismounted to cool the reaction solvent. As a result, the reaction was terminated. After the temperature of the solution became less than 80°C, 10 ml of methanol was added to allow the nanocrystals to be precipitated from the reaction mixture. The precipitated product was separated by centrifugation and decantation. The nanocrystals were kept as a precipitate or were subjected to drying under reduced pressure. The nanocrystals obtained by the use of this reaction had a wide particle size distribution, with a standard deviation exceeding 20%.
The resulting semiconductor nanocrystals were dispersed in a urethane-based heat-curable resin (MIG2500 manufactured by Jujo Chemical Co., Ltd.) as a matrix resin such that the concentration per solid matter of the semiconductor nanocrystals become 9 wt% (volume ratio: 2 vol%), whereby a fluorescence medium material 2 using the semiconductor nanocrystals (InP) was prepared.

### Preparation Example 3

### Preparation of a fluorescence medium material 3 using an organic fluorescence material (a perylene-based pigment)

As a perylene-based pigment, 0.3 wt% (concentration per solid matter) of a compound shown by the following formula (Ia), 0.6 wt% (concentration per solid matter) of a compound shown by the following formula (IIa) and 0.6 wt% (concentration per solid matter) of a compound by the following formula (IIIa) were each dissolved in the same matrix resin as in Preparation Example 1, whereby a fluorescence medium material 3 using the perylene-based pigment was prepared.

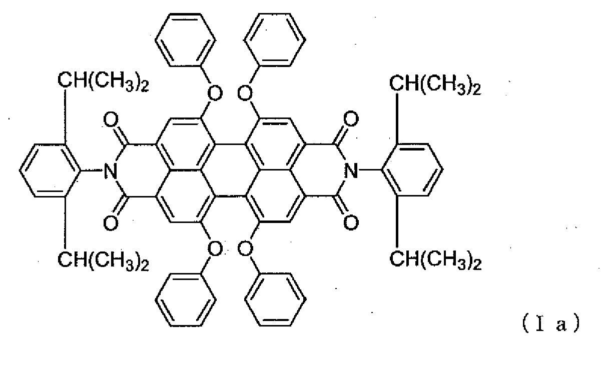

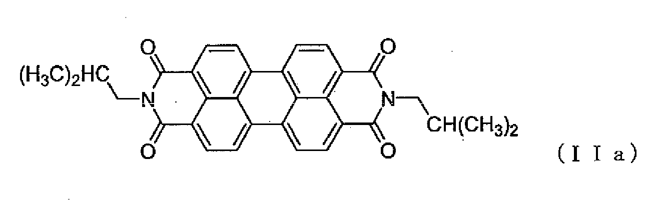

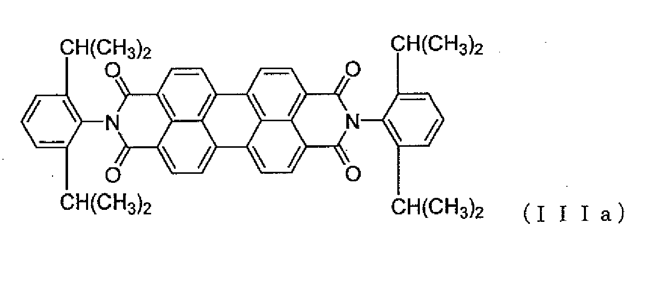

### Preparation Example 4

### Preparation of a fluorescence medium material 4 using an organic fluorescence material (perylene-based pigment)

0.6 wt% (concentration per solid matter) of a compound shown by the formula (IIa) was dissolved in the same matrix resin as in Preparation Example 1, whereby a fluorescence medium material 4 using a perylene-based pigment was prepared.

### Example 1

On a glass plate substrate with a dimension of 100 mm × 100 mm × 1.1 mm (thickness) (manufactured by Geomatics Co., Ltd.), the fluorescence medium material 1 obtained in Prepareaion Example 1 was screen-printed using a stripe pattern plate with a line of 30 µm and a gap of 10 µm. After drying at 80°C, the material was allowed to cure at 180°C. The fluorescence medium was caused to flow by performing the treatment at 180°C, whereby a fluorescence medium pattern having a cross section shape shown in FIG. 13(a) was formed.
Then, this substrate was moved to a sputtering apparatus, where an IZO (indium-zinc oxide) layer was formed on the entire surface in a thickness of about 2000Å. IZO is amorphous and forms a dense film. Therefore, the IZO film sufficiently suppresses degasification of moisture or the like from the fluorescence medium.
Then, ultrasonic cleaning was conducted for 5 minutes in isopropyl alcohol, followed by UV ozone cleaning for 30 minutes.
First, on the IZO electrode, an HI film which functioned as a hole-injecting layer was deposited in a thickness of 25 nm. Subsequently, an HT film which functioned as a hole-transporting layer was deposited in a thickness of 10 nm. Then, as a blue-emitting layer, the compound BH and the compound BD were co-deposited in a thickness of 10 nm such that the thickness ratio of BH to BD became 10:0.5. Subsequently, as a green-emitting layer, the compound BH and the compound GD were co-deposited in a thickness of 10 nm such that the thickness ratio of BH to GD became 10:0.8. On this film, as an electron-transporting layer, a tris(8-quinolinol)aluminum film (hereinafter abbreviated as an "Alq film") was formed in a thickness of 10 nm, Subsequently, LiF was deposited as an electron-injecting layer in a thickness of 1 nm and, Al was deposited as a cathode in a thickness of 150 nm, thereby fabricating a blue-green-light-emitting organic EL device. The emission spectrum of this blue-green-light-emitting organic EL device was measured. The results showed that the emission spectrum had an emission peak at 457 nm in the blue region and an emission peak at 528 nm in the green region.
Then, a 0.3 mm-thick glass substrate (the same glass substrate as mentioned above) was adhered to this organic EL device by using an adhesive to seal the organic EL device, whereby a light emitting apparatus was obtained (FIG. 13 (a) in which a sealing member was not shown).
A DC voltage (7 V) was applied to the IZO electrode and the Al electrode of this apparatus (IZO electrode: (+), Al electrode: (-)). As a result, the light from the organic EL device and the fluorescence from the fluorescence medium were mixed, whereby white emission was obtained.
Chromaticity was measured from the front and obliquely at an angle of 45° by means of a colorimeter (CS100, manufactured by Konica Minolta Corporation). The observed difference in CIE chromaticity was within 0.01.

### Example 2

A light emitting apparatus shown in FIG. 13 (c) (in which a sealing member was not shown) was obtained in the same manner as in Example 1, except that the fluorescence medium material 1 prepared in Preparation Example 1 was screen-printed by using a stripe pattern plate with a line of 30 µm and a gap of 30 µm.
Subsequently, a DC voltage (7 V) was applied to the IZO electrode and the Al electrode of this apparatus (IZO electrode: (+), Al electrode: (-)). As a result, the light from the organic EL device and the fluorescence from the fluorescence medium were mixed, whereby white emission was obtained.
Chromaticity was measured from the front and obliquely at an angle of 45° by means of a colorimeter (CS100, manufactured by Konica Minolta Corporation). The observed difference in CIE chromaticity was within 0.01.

### Example 3

A light emitting apparatus having a pattern shown in FIG. 13(a) (in which a sealing member was not shown) was obtained in the same manner as in Example 1, except that the fluorescence medium material 2 prepared in Preparation Example 2 was used.
Subsequently, a DC voltage (7 V) was applied to the IZO electrode and the Al electrode of this apparatus (IZO electrode: (+), Al electrode: (-)). As a result, the light from the organic EL device and the fluorescence from the fluorescence medium were mixed, whereby white emission was obtained.
Chromaticity was measured from the front and obliquely at an angle of 45° by means of a colorimeter (CS100, manufactured by Konica Minolta Corporation). The observed difference in CIE chromaticity was within 0.01.

### Example 4

A light emitting apparatus having a pattern shown in FIG. 13(a) (in which a sealing member was not shown) was obtained in the same manner as in Example 1, except that the fluorescence medium material 3 prepared in Preparation Example 3 was used.
Subsequently, a DC voltage (7 V) was applied to the IZO electrode and the Al electrode of this apparatus (IZO electrode: (+), Al electrode: (-)). As a result, the light from the organic EL device and the fluorescence from the fluorescence medium were mixed, whereby white emission was obtained.
Chromaticity was measured from the front and obliquely at an angle of 45° by means of a colorimeter (CS100, manufactured by Konica Minolta Corporation). The observed difference in CIE chromaticity was within 0.01.

### Example 5

A light emitting apparatus having a pattern shown in FIG. 13(a) (in which a sealing member was not shown) was obtained in the same manner as in Example 1, except that the fluorescence medium material 3 prepared in Preparation Example 3 was used and, as the emitting layer of the organic EL device, the compound BH and the compound BD were co-deposited in a thickness of 10 nm such that the thickness ratio of BH to BD became 10:0.5 to allow the organic EL device to have an emission peak at 457 nm in the blue region.
Subsequently, a DC voltage (7 V) was applied to the IZO electrode and the Al electrode of this apparatus (IZO electrode: (+), Al electrode: (-)). As a result, the light from the organic EL device and the fluorescence from the fluorescence medium were mixed, whereby white emission was obtained.
Chromaticity was measured from the front and obliquely at an angle of 45° by means of a colorimeter (CS100, manufactured by Konica Minolta Corporation). The observed difference in CIE chromaticity was within 0.01.

### Example 6

A light emitting apparatus having a pattern shown in FIG. 13(c) (in which a sealing member was not shown) was obtained in the same manner as in Example 1, except that the fluorescence medium material 4 prepared in Preparation Example 4 was used and, as the emitting layers of the organic EL device, the compound BH and the compound BD were co-deposited in a thickness of 10 nm such that the thickness ratio of BH to BD became 10:0.5 for the blue-emitting layer and the compound BH and the compound RD were co-deposited in a thickness of 20 nm such that the thickness ratio of BH to RD became 20:3 for the red-emitting layer to allow the organic EL device to have an emission peak at 457 nm in the blue region and an emission peak at 615 nm in the red region.
Subsequently, a DC voltage (7 V) was applied to the IZO electrode and the Al electrode of this apparatus (IZO electrode: (+), Al electrode: (-)). As a result, the light from the organic EL device and the fluorescence from the fluorescence medium were mixed, whereby white emission was obtained.
Chromaticity was measured from the front and obliquely at an angle of 45° by means of a colorimeter (CS100, manufactured by Konica Minolta Corporation). The observed difference in CIE chromaticity was within 0.01.

### Example 7

A light emitting apparatus of top-emission type having a pattern shown in FIG. 13(a) (in which a sealing member was not shown) was obtained in the same manner as in Example 1, except that the glass substrate with a dimension of 100 mm × 100 mm × 1.1 mm (thickness) (manufactured by Geomatics Co., Ltd.) on which a 2000Å-thick Al film was formed was used, an IZO film was used as a cathode and the organic EL device was sealed by an SiON film.
Subsequently, a DC voltage (7 V) was applied to the IZO electrode and the Al electrode of this apparatus (IZO lower electrode: (+), IZO upper electrode: (-)). As a result, the light from the organic EL device and the fluorescence from the fluorescence medium were mixed, whereby white emission was obtained.
Chromaticity was measured from the front and obliquely at an angle of 45° by means of a colorimeter (CS100, manufactured by Konica Minolta Corporation). The observed difference in CIE chromaticity was within 0.01.

### Example 8

A fluorescence medium having a pattern shown in FIG. 13 (c) was formed on the supporting substrate in the same manner as in Example 1, except that the fluorescence medium material 1 prepared in Preparation Example 1 was screen-printed by means of a stripe pattern plate with a line of 30 µm and a gap of 30 µm.
Subsequently, the fluorescence medium and the part of the supporting substrate other than the part on which the fluorescence medium was formed were covered by a commercially available photo-resist. The resultant was subjected to a treatment with hydrofluoric acid, whereby a concave-shaped recess was formed in the gap of the fluorescence medium pattern.
After the photo-resist was removed by an organic alkali (ethanolamine) treatment, formation of an IZO film, formation of an organic EL device and sealing were performed in the same manner as in Example 1, whereby light emitting apparatus shown in FIG. 13(d) (in which a sealing member was not shown) was obtained.
Subsequently, a DC voltage (7 V) was applied to the IZO electrode and the Al electrode of this apparatus (IZO electrode: (+), Al electrode: (-)). As a result, the light from the organic EL device and the fluorescence from the fluorescence medium were mixed, whereby white emission was obtained.
Chromaticity was measured from the front and obliquely at an angle of 45° by means of a colorimeter (CS100, manufactured by Konica Minolta Corporation). The observed difference in CIE chromaticity was within 0.01.

### Example 9

A fluorescence medium having a pattern shown in FIG. 13 (c) was formed on the supporting substrate in the same manner as in Example 1, except that the fluorescence medium material 1 prepared in Preparation Example 1 was screen-printed by means of a stripe pattern plate with a line of 30 µm and a gap of 30 µm.
Subsequently, the gap of the pattern of the fluorescence medium 1 was screen-printed by using a urethane-based heat-curable resin ink (MIG 2500 manufactured by Jujo Chemical Co., Ltd) and a stripe pattern plate with a line of 30 µm and a gap of 30 µm, dried at 80°C, and cured at 180°C, whereby a transparent convex was formed in the gap of the fluorescence medium. Then, formation of an IZO film, formation of an organic EL device and sealing were performed in the same manner as in Example 1, whereby light emitting apparatus shown in FIG. 13 (e) (in which a sealing member was not shown) was obtained.
Subsequently, a DC voltage (7 V) was applied to the IZO electrode and the Al electrode of this apparatus (IZO electrode: (+) , Al electrode: (-)). As a result, the light from the organic EL device and the fluorescence from the fluorescence medium were mixed, whereby white emission was obtained.
Chromaticity was measured from the front and obliquely at an angle of 45° by means of a colorimeter (CS100, manufactured by Konica Minolta Corporation). The observed difference in CIE chromaticity was within 0.01.

### Comparative Example 1

A light emitting apparatus was obtained in the same manner as in Example 1, except that the fluorescence medium material was spin coated to form a flat fluorescence medium and an ITO electrode (crystalline) with a thickness of 2000Å was used as an anode.
Subsequently, a DC voltage (7 V) was applied to the IZO electrode and the Al electrode of this apparatus (IZO electrode: (+) , Al electrode: (-)). As a result, the light from the organic EL device and the fluorescence from the fluorescence medium were mixed, whereby white emission was obtained.
Chromaticity was measured from the front and obliquely at an angle of 45° by means of a colorimeter (CS100, manufactured by Konica Minolta Corporation). The observed difference in CIE chromaticity exceeded 0.01, which means the light emitting apparatus of this comparative example was inferior to those of the examples in the uniformity of emission. The reason therefor is assumed to be the angle-dependent difference of the emission spectrum of the organic EL device and the intensity of the light which has transmitted the fluorescence medium.
In addition, the luminance of the white light was about 80% of that obtained in Example 1. A smaller emitting area of the organic EL device than that in Example 1 appears to be the reason for this poor white color luminance.
Furthermore, the emitting device suffered from a large amount of dark spots caused by moisture or the like. It was revealed that the barrier properties of the ITO film (crystalline) were poorer than those of the IZO film (amorphous).

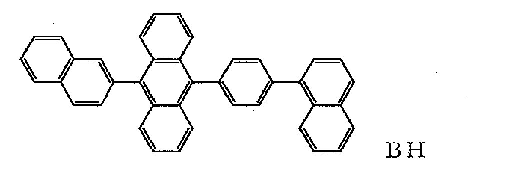

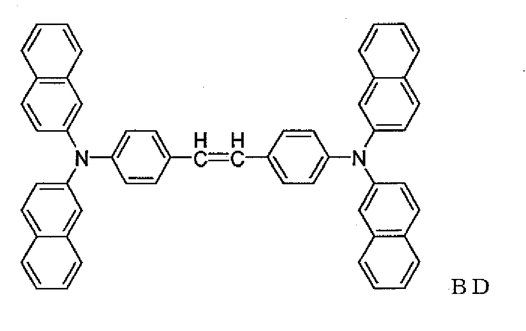

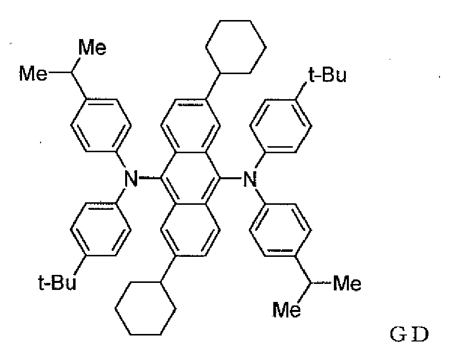

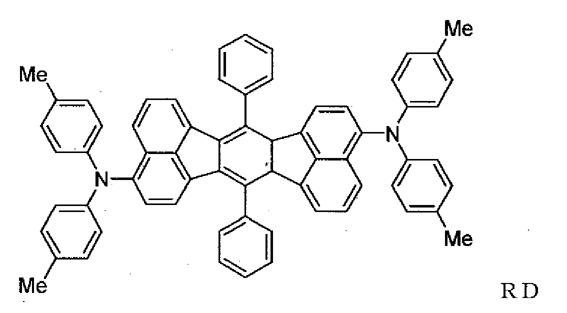

### Preparation Example 5 (Preparation of a red fluorescence medium material 1)

Cadmium acetate dehydrate (0.5 g) and tetradecylphosphonic acid (TDPA) (1.6 g) were added to 5 ml of trioctylphosphine (TOP). Under nitrogen atmosphere, the resulting solution was heated to 230°C, and stirred for one hour. After cooling to 60°C, 2 ml of a TOP solution containing 0.2g of selenium was added, whereby a raw material solution was obtained.
Trioctylphophine oxide (TOPO) (10 g) was put in a three neck flask, and vacuum-dried at 195°C for one hour. The pressure was raised to atmospheric pressure by a nitrogen gas. The flask was then heated at 270°C in the nitrogen atmosphere. While stirring the system, 1.5 ml of the above-obtained raw material solution was added. The reaction (core growth reaction) was allowed to proceed while occasionally checking the fluorescent spectrum of the reaction solution. When the nanocrystals grew to have a fluorescence peak at 615 nm, the reaction solution was cooled to 60°C to terminate the reaction. Then, 20 ml of butanol was added to cause the semiconductor nanocrystals (core) to precipitate, and separated by centrifugation. The separated nanocrytals were dried under reduced pressure.

TOPO (5 g) was put in a three neck flask, and vacuum-dried at 195°C for one hour. The pressure was raised to atmospheric pressure by a nitrogen gas. The flask was cooled to 60°C in the nitrogen atmosphere. Then, the above-mentioned semiconductor nanocrystals (core) (0.05 g) which had been suspended in 0.5 ml of TOP and 0.5 ml of hexane was added. The resulting mixture was stirred for one hour at 100°C under reduced pressure, and then heated to 160°C. The pressure was raised to atmospheric pressure by a nitrogen gas (Solution A).
Solution B which had been prepared separately (prepared by dissolving 0.7 ml of a 1N n-hexane solution of diethyl zinc and bis(trimethylsilyl)sulfide (0.13 g) in 3 ml of TOP) was added dropwise to solution A which was kept at 160°C for 30 minutes. After cooling to 90°C, stirring was continued for further 2 hours. After cooling to 60°C, 20 ml of butanol was added to cause the semiconductor nanocrystals (core: CdSe/shell: ZnS) to precipitate, and separated by centrifugation. The separated semiconductor nanocrystals were dried under reduced pressure.
The resulting semiconductor nanocrystals were dispersed in an acrylic negative-type UV-curable resin (V259 manufactured by Nippon Steel Chemical Co., Ltd.) as a matrix resin such that the concentration per solid matter of the semiconductor nanocrystals became 9 wt% (volume ratio: 2 vol%), whereby a red fluorescence medium material 1 using the semiconductor nanocrystals ((CdSe)ZnS) was prepared.

### Preparation Example 6 (Preparation of a red fluorescence material 2)

A red fluorescence material 2 was prepared in the same manner as in Preparation Example 5, except that a urethane-based heat-curable resin (MIG2500 manufactured by Jujo Chemical Co., Ltd.) was used as a matrix resin.

### Preparation Example 7 (Preparation of a green fluorescence material 3)

Semiconductor nanocrystals (core: CdSe/shell: ZnS) were synthesized in the same manner as in Example 5, except that the core growth reaction was allowed to proceed until the nanocrystals had a fluorescence peak at 530 nm, whereby a green fluorescence medium material 3 was obtained.

### Preparation Example 8 (Preparation of a green fluorescence material 4)

Semiconductor nanocrystals (core: CdSe/shell: ZnS) were synthesized in the same manner as in Example 6, except that the core growth reaction was allowed to proceed until the nanocrystals had a fluorescence peak at 530 nm, whereby a green fluorescence material 4 was obtained.

### Example 10

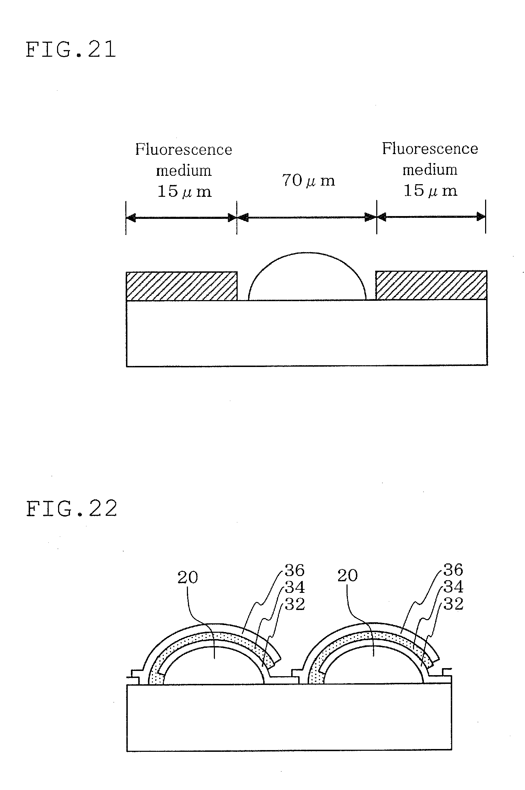

On a glass plate substrate with a dimension of 25 mm × 75 mm × 0.7 mm (thickness), the red fluorescence material 1 obtained in Preparation Example 5 was applied. Then, the material was exposed through a photo-mask such that a 70 µm-square opening could be formed and a frame having an outer circumference width of 15 µm was left in a 100 µm-square area, followed by development. The resultant was heated at 180°C to cure to form a fluorescence conversion part with a thickness of 5 µm. Thereafter, by using a screen pattern plate, a urethane-based heat-curable resin (MIG2500, manufactured by Jujo Chemical Co., Ltd.) was printed in the 70 µm-opening and dried at 80°C. By conducting heat treatment at 180°C, the resin was flown, whereby a resin pattern with a thickness of the central part of 10 µm and having a cross section shape as shown in FIG. 21 was obtained.

Then, the substrate was moved to a sputtering apparatus. An ITO (indium-tin oxide) layer was formed on the entire surface with a thickness of about 2000Å. A positive-type resist (HPR 204, manufactured by Fuji Film Arch Co., Ltd.) was spin-coated thereon, and exposed to UV rays through a photo-mask such that the ITO remained only in the resin pattern part. Then, the resultant was developed with a developer of TMAH (tetramethylammonium hydroxide) and baked at 130°C, whereby a resist pattern was obtained. Subsequently, the ITO in the exposed portion was removed by etching with an ITO etchant composed of 47% hydrobromic acid. Then, the resist was treated with a peeling agent composed mainly of ethanolamine (N303, manufactured by Nagase Co., Ltd.), whereby an ITO pattern (a lower transparent electrode: anode) was obtained.
Subsequently, ultrasonic cleaning was conducted in isopropyl alcohol for 5 minutes, and then UV-ozone cleaning was conducted for 30 minutes.

An HI film which functioned as a hole-injecting layer was deposited in a thickness of 25 nm. Subsequently, an HT film which functioned as a hole-transporting layer was deposited in a thickness of 10 nm. Then, as a blue-emitting layer, the compound BH and the compound BD were co-deposited in a thickness of 10 nm such that the thickness ratio of BH to BD became 10:0.5. Subsequently, as a green-emitting layer, the compound BH and the compound GD were co-deposited in a thickness of 10 nm such that the thickness ratio of BH to GD became 10:0.8. On this film, as an electron-transporting layer, a tris(8-quinolinol)aluminum film (hereinafter abbreviated as an "Alq film") was formed in a thickness of 10 nm. Subsequently, LiF was deposited in a thickness of 1 nm as an electron-inj ecting layer, Al as a cathode (upper reflective electrode) was deposited in a thickness of 150 nm, thereby fabricating a blue-green-emitting organic EL device. The same blue-green-emitting organic EL device was separately formed on a glass substrate and the emission spectrum thereof was measured. The results showed that the emission spectrum had an emission peak at 457 nm in the blue region and an emission peak at 528 nm in the green region.

Then, a 0.3 mm-thick glass substrate (the same glass substrate as mentioned above) was adhered to this organic EL device by using an adhesive to seal the organic EL device, whereby an organic EL apparatus was obtained (FIG. 20(a) in which a sealing member was not shown).
A DC voltage (7 V) was applied to the ITO electrode and the Al electrode of this apparatus (ITO electrode: (+), Al electrode: (-)). As a result, the light from the organic EL device and the fluorescence from the fluorescence medium were mixed, whereby white emission was obtained.
Chromaticity was measured by means of a colorimeter (CS100, manufactured by Konica Minolta Corporation). The shift in chromaticity and the relative value of luminance based on the luminance and chromaticity measured at the front of the light emitting apparatus in each Example was shown in Table 1.

### Comparative Example 2

An organic EL apparatus was fabricated in the same manner as in Example 10, except that the projected resin pattern was not formed before the fabrication of the emitting device part. In the same manner as in Example 10, the chromaticity and luminance of the organic EL apparatus were evaluated. The results are shown in Table 1. The results in Table 1 revealed that the chromaticity and luminance were changed depending on the viewing angle as compared with Example 10.

### Example 11

On a glass plate substrate with a dimension of 25 mm × 75 mm × 0.7 mm (thickness) (manufactured by Geomatics Co., Ltd.), a urethane-based heat-curable resin (MIG2500, manufactured by Jujo Chemical Co., Ltd.) was printed in a 70 µm-square shape, by means of a 100 µm-pitch screen plate. After drying at 80°C, heat treatment was conducted at 180°C to adjust the shape. Thereafter, an Al film was formed on the entire surface in a thickness of 100 nm by sputtering.
Thereafter, by using the green fluorescence material 3 prepared in Preparation Example 7, exposure and development were conducted by means of the same photo-mask as that used in Example 10, whereby a fluorescence conversion part was formed.
Next, film formation was conducted by using a cluster-type film-forming apparatus in which an organic EL vapor deposition apparatus and an ion-plating chamber for forming an ITO film were connected. Each layer of the organic EL apparatus was formed by vacuum vapor deposition as in the case of Example 10. However, in Example 11, instead of the green emitting layer, the compound BH and the compound RD were co-deposited in a thickness of 20 nm such that the thickness ratio of BH to RD became 20:3, whereby a blue-red-emitting device was fabricated. Furthermore, instead of the Al electrode, an Mg:Ag metal (9:1 in composition) was deposited in a thickness of 10 nm. Thereafter, while maintaining a vacuum, the substrate was transferred to an ion plating chamber, and an ITO film was formed. Furthermore, as a sealing film, an SiON film was formed in the same chamber by changing the source of ion plating, whereby a top-emitting organic EL apparatus was obtained (see FIG. 20 (b), in which the sealing part is not shown) . The same blue-red-emitting device was separately formed on a glass substrate and the emission spectrum thereof was measured. The results showed that the emission spectrum had an emission peak at 457 nm in the blue region and an emission peak at 615 nm in the red region.
Subsequently, a DC voltage (7 V) was applied to the ITO electrode and the Al electrode of this apparatus (ITO electrode: (+), Al electrode: (-)). As a result, the light from the organic EL device and the fluorescence from the fluorescence medium were mixed, whereby white emission was obtained.
Chromaticity was measured from the front and obliquely at an angle of 45° by means of a colorimeter (CS100, manufactured by Konica Minolta Corporation). The results obtained are shown in Table 1.

### Comparative Example 3

An organic EL apparatus was fabricated in the same manner as in Example 11, except that the projected resin pattern was not formed before the fabrication of the emitting device part. In the same manner as in Example 11, the chromaticity and luminance of the organic EL apparatus were evaluated. The results are shown in Table 1. The results in Table 1 revealed that the chromaticity and luminance were changed depending on the viewing angle as compared with Examples 11.

### Example 12

On a glass plate substrate with a dimension of 25 mm × 75 mm × 0.7 mm (thickness), the red fluorescent material 2 obtained in Preparation Example 6 was applied to the entire device fabrication area. After drying at 80°C, the substrate was heat-cured at 180°C. Thereafter, the same material was printed in a 70 µm-square shape by means of a 100 µm-pitch screen plate. After drying at 80°C, heat treatment was conducted at 180°C to adjust the projected shape.
In the same manner as in Example 10, an organic EL apparatus was fabricated (FIG. 20(c), in which a sealing part is not shown).
Subsequently, a DC voltage (7 V) was applied to the ITO electrode and the Al electrode of this apparatus (ITO electrode: (+), Al electrode: (-)). As a result, the light from the organic EL device and the fluorescence from the fluorescence medium were mixed, whereby white emission was obtained.
Chromaticity was measured from the front and obliquely at an angle of 45° by means of a colorimeter (CS100, manufactured by Konica Minolta Corporation). The results obtained are shown in Table 1.

### Comparative Example 4

An organic EL apparatus was fabricated in the same manner as in Example 12, except that the projected resin pattern was not formed before the fabrication of the emitting device part. In the same manner as in Example 12, the chromaticity and luminance of the organic EL apparatus were evaluated. The results are shown in Table 1. The results in Table 1 revealed that the chromaticity and luminance were changed depending on the viewing angle as compared with Example 12.

### Example 13

On a polyimide sheet with a dimension of 25 mm × 75 mm × 100 µm (thickness), the green fluorescence material 4 obtained in Preparation Example 8 was applied to the entire device fabrication area. After drying at 80°C, the substrate was heat-cured at 180°C. Thereafter, the same material was printed by means of a screen plate in a shape of a frame having an outer circumference width of 15 µm in a 100 µm-square area with a 70 µm-square non-printed part therein. After drying at 80°C, heat treatment was conducted at 180°C, whereby a frame (bank) was formed.
Thereafter, in the same manner as in Example 10, an emitting device was fabricated within the frame. Thereafter, this light emitting apparatus was moved to a nitrogen-replaced glove box, and the light emitting apparatus was transferred on the substrate for transfer, whereby an organic EL apparatus was fabricated (FIG. 20(d), in which a sealing part is not shown). The substrate for transfer was obtained by applying to a glass substrate (25 mm × 7 5 mm × 0.7 mm (thickness)) a toluene solution of 8 wt% of ethylene-ethyl acrylate resin and 8 wt% of ethylene vinyl acetate, followed by heating at 150°C for 30 minute, drying the solvent and forming a thermoplastic resin layer (2 µm).
Subsequently, a DC voltage (7 V) was applied to the ITO electrode and the Al electrode of this apparatus (ITO electrode: (+), Al electrode: (-)). As a result, the light from the organic EL device and the fluorescence from the fluorescence medium were mixed, whereby white emission was obtained.
Chromaticity was measured from the front and obliquely at an angle of 45° by means of a colorimeter (CS100, manufactured by Konica Minolta Corporation). The results obtained are shown in Table 1. The results shown in Table 1 revealed that the apparatus of Example 13 was less dependent on the viewing angle and had improved light outcoupling properties as compared with the apparatus of Comparative Example 2.

### Comparative Example 5

An organic EL apparatus was fabricated in the same manner as in Example 13, except that the projected fluorescence resin pattern was not formed before the fabrication of the emitting device part. In the same manner as in Example 13, the chromaticity and luminance of the organic EL apparatus were evaluated. The results are shown in Table 1. The results in Table 1 revealed that the chromaticity and luminance were changed depending on the viewing angle as compared with Example 13.

### Example 14

An emitting device was fabricated in the same manner as in Example 11. An emitting device was continuously formed thereon, whereby a top-emitting light emitting apparatus was fabricated.

### Example 15

An organic EL apparatus was fabricated in the same manner as in Example 11. In fabricating an emitting device, during the formation of an upper electrode (ITO) which is a final step, the patterning of a lower electrode and masking of an organic layer were changed in advance such that the upper electrode could be connected to the lower electrode of the adjacent emitting device. FIG. 20 (b) shows the light emitting apparatus as viewed from a long side and FIG. 22 shows the light emitting apparatus as viewed from a short side.

**Table 1**

| | Front | | Oblique 45° | |
|---|---|---|---|---|
| | Shift in chromaticity | Relative luminance | Chromaticity | Relative luminance |
| Example 10 | (0.00, 0.00) | 1.00 | (0.00, -0.01) | 0.92 |
| Com. Ex. 2 | (0.01, 0.00) | 0.92 | (-0.02. -0.03) | 0.79 |
| Example 11 | (0.00, 0.00) | 1.00 | (0.00, 0.00) | 0.92 |
| Com. Ex. 3 | (0.00, 0.01) | 0.88 | (0.02, 0.00) | 0.66 |
| Example 12 | (0.00, 0.00) | 1.00 | (0.00, -0.01) | 0.96 |
| Com. Ex. 4 | (0.01, 0.00) | 0.85 | (-0.02, -0.03) | 0.73 |
| Example 13 | (0.00, 0.00) | 1.00 | (0.00, 0.00) | 0.83 |
| Com. Ex. 5 | (0.00, 0.01) | 0.76 | (0.02, -0.01) | 0.59 |
| Example 14 | (0.00, 0.00) | 1.00 | (0.01, -0.01) | 0.93 |
| Example 15 | (0.00, 0.00) | 1.00 | (0.01, -0.01) | 0.91 |

### INDUSTRIAL APPLICABILITY

The light emitting apparatus of the invention can be used as a common illuminator and a light source of a backlight (for liquid crystal display).

## Claims

1. A light emitting apparatus comprising:
a supporting substrate, a fluorescence medium and an emitting device for covering the fluorescence device;
the emitting device having two or more emitting surfaces which are not parallel to each other;
wherein the light emitting apparatus emits light obtained by mixing light emitted by the emitting device and light emitted by the fluorescence medium.

2. The light emitting apparatus according to claim 1, wherein, when light rays are emitted from the emitting surfaces which are not parallel to each other in the normal directions to the emitting surfaces, and transmit the fluorescence medium, transmission distances in the fluorescence medium are substantially equal.

3. The light emitting apparatus according to claim 1 or 2, wherein the fluorescence medium is in a convex shape.

4. The light emitting apparatus according to any one of claims 1 to 3, wherein part of the emitting device covers the fluorescence medium and part of the emitting device does not cover the fluorescence medium.

5. The light emitting apparatus according to claim 4,
wherein a convex part or a concave part is provided on the supporting substrate, and the part of the emitting device which does not cover the fluorescence medium is formed on the convex part or the concave part.

6. The light emitting apparatus according to any one of claims 1 to 5, wherein a convex part is provided on the supporting substrate, and the fluorescence medium is formed on the convex part in a substantially uniform thickness.

7. The light emitting apparatus according to any one of claims 1 to 6, wherein a transparent barrier layer is further provided between the emitting device and the fluorescence medium.

8. The light emitting apparatus according to any one of claims 1 to 7, wherein a transparent electrode of the emitting device functions as a transparent barrier layer.

9. The light emitting apparatus according to any one of claims 1 to 8, wherein a concave part is provided on the supporting substrate, and the emitting device and the fluorescence medium are formed within the concave part.

10. The light emitting apparatus according to any one of claims 1 to 9, wherein light emitted by the emitting device and light emitted by the fluorescence medium are outcoupled from the supporting substrate.

11. The light emitting apparatus according to any one of claims 1 to 9, wherein light emitted by the emitting device and light emitted by the fluorescence medium are outcoupled in the direction away from the supporting substrate.

12. The light emitting apparatus according to any one of claims 1 to 11, wherein the fluorescence medium contains a nanocrystal fluorescent material.

13. The light emitting apparatus according to claim 12, wherein the nanocrystal fluorescent material is a semiconductor nanocrystal.

14. The light emitting apparatus according to any one of claims 1 to 13, wherein the emitting device is an organic electroluminescence device.

15. The light emitting apparatus according to any one of claims 1 to 14, wherein light obtained by mixing the light emitted by the emitting device and the light emitted by the fluorescence medium is white.

16. A light emitting apparatus comprising:
a supporting substrate, an emitting device having two or more emitting surfaces which are not parallel to each other and a fluorescence medium;
the fluorescence medium being disposed in a direction different from the direction in which light emitted by the emitting device is outcoupled;
wherein the light emitting apparatus emits light obtained by mixing light emitted by the emitting device and light emitted by the fluorescence medium.

17. The light emitting apparatus according to claim 16, wherein the surface of the emitting device is in a convex shape.

18. The light emitting apparatus according to claim 16 or claim 17, wherein the surface of the fluorescence medium is in a convex shape.

19. The light emitting apparatus according to claim 17 or claim 18, wherein the convex shape is a semi-spherical shape.

20. The light emitting apparatus according to any of claims 16 to 19, wherein the fluorescence medium is arranged in a direction perpendicular to the direction in which the light emitted by the emitting device is outcoupled.

21. The light emitting apparatus according to any one of claims 16 to 20, wherein two or more emitting devices are arranged on the supporting substrate, and the fluorescence medium is between the two or more emitting devices.

22. The light emitting apparatus according to any one of claims 16 to 21, wherein the emitting device is embedded in the fluorescence medium.

23. The light emitting apparatus according to any one of claims 16 to 22, wherein the two or more emitting devices are stacked.

24. The light emitting apparatus according to any one of claims 16 to 23, wherein the light emitted by the emitting device and the light emitted by the fluorescence medium are outcoupled from the supporting substrate.

25. The light emitting apparatus according to any one of claims 16 to 23, wherein the light emitted by the emitting device and the light emitted by the fluorescence medium are outcoupled in the direction away from the supporting substrate.

26. The light emitting apparatus according to any one of claims 16 to 25, wherein the fluorescent medium contains a nanocrystal fluorescent material.

27. The light emitting apparatus according to claim 26, wherein the nanocrystal fluorescent material is a semiconductor nanocrystal.

28. The light emitting apparatus according to any one of claims 16 to 27, wherein light obtained by mixing the light emitted by the emitting device and the light emitted by the fluorescence medium is white.
